Europäisches Patentamt

(19) European Patent Office

Office européen des brevets

(11) EP 0 864 929 A2

(12) EUROPEAN PATENT APPLICATION

(43) Date of publication:
16.09.1998 Bulletin 1998/38

(51) Int. Cl.⁶: **G03F 7/20**, G03F 9/00

(21) Application number: 98104391.2

(22) Date of filing: 11.03.1998

(84) Designated Contracting States:
AT BE CH DE DK ES FI FR GB GR IE IT LI LU MC NL PT SE
Designated Extension States:
AL LT LV MK RO SI

(30) Priority: 11.03.1997 JP 56373/97
25.06.1997 JP 168420/97

(71) Applicant: Nikon Corporation
Tokyo 100-8831 (JP)

(72) Inventors:
• Yoshida, Koji,
c/o Nikon Corporation
Chiyoda-ku, Tokyo 100-8331 (JP)
• Kiyohara, Junya,
c/o Nikon Corporation
Chiyoda-ku, Tokyo 100-8331 (JP)

(74) Representative:
von Fischern, Bernhard, Dipl.-Ing. et al
Hoffmann - Eitle,
Patent- und Rechtsanwälte,
Arabellastrasse 4
81925 München (DE)

(54) **Determining method of movement sequence and alignment apparatus for executing the same**

(57)     A determining method of movement sequence and a alignment apparatus according to the present invention are arranged in such a manner that, in order to measure positions of plural marks as being measurement targets provided on a wafer within a shorter time, a group including a plurality of executable movement sequences is generated out of a group of movement sequence candidates, each indicating a measurement order of these marks, and a movement sequence that accomplishes a movement operation between the plural marks within the shortest time is obtained from the group thus generated.

*Fig. 15*

EP 0 864 929 A2

**Description**

BACKGROUND OF THE INVENTION

Field of the Invention

The present invention relates to a determining method of movement sequence, for example, for reducing the time of alignment between a pattern of an original plate and marks on a substrate in exposure apparatus, and to an alignment apparatus for carrying out the determining method.

Related Background Art

In general, the exposure apparatus is arranged in such a way that, before carrying out exposure of the second layer or a layer thereafter into chip areas (or shot areas) on a wafer (photosensitive substrate) in which predetermined circuit patterns are to be formed, alignment is accomplished between a pattern of an original plate for the second or subsequent layer and the chip areas by use of EGA (a statistical arithmetic method). The EGA (Enhanced Global Alignment) is a technique for measuring positions of alignment marks (measured areas) provided mainly in the peripheral area of a plurality of selected chip areas to obtain a residual rotation error of the wafer, linear expansion or contraction of the wafer, an offset of the wafer, etc. and, based thereon, aligning the all chip areas of the wafer, for example, as disclosed in Japanese Laid-open Patent Application No. sho 61-44429. As another technique of a further development of the EGA, United States Patent No. 4,780,617 discloses an alignment technique for obtaining a residual rotation error of each chip area itself, an orthogonality error of the chip areas, and linear expansion or contraction of each chip area itself and performing alignment so as to minimize even these errors.

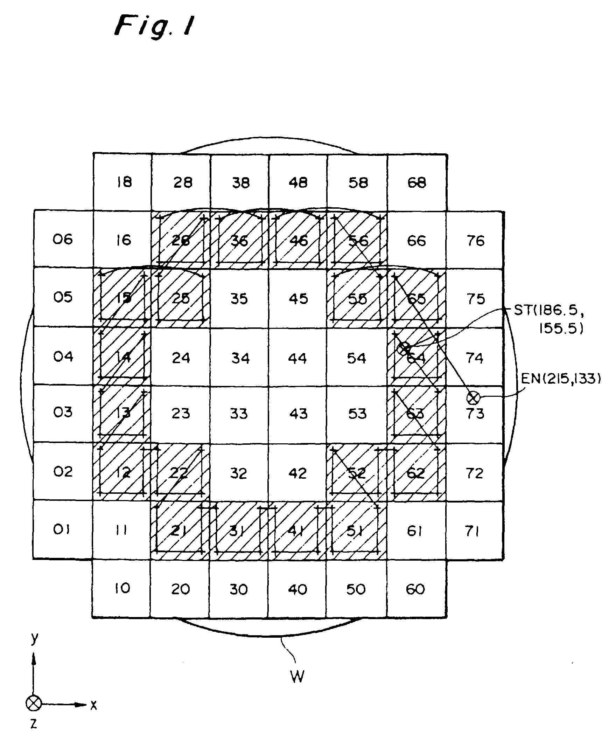

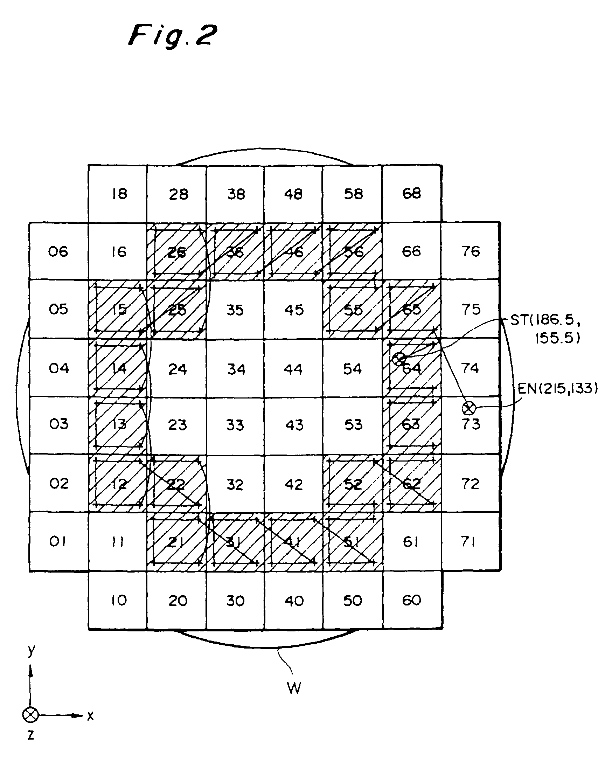

Particularly, when the technique of Japanese Laid-open Patent Application No. Hei 6-275496 is applied, because of the many alignment marks to be measured, the measurement time will be very long unless the alignment marks are measured as efficient as possible. For example, let us consider an example in which there are 76 exposed chip areas (areas indicated by number 01 to number 76 in the figure) in the first layer of the wafer W and four alignment marks are provided for each of the chip areas, as shown in Fig. 1. In this case, in the alignment of wafer by the EGA, the operator first selects a plurality of chip areas that are inside the outermost region and at vertices of polygon (for example, twenty chip areas hatched in Fig. 2), on an empirical basis. Coordinates of the designed center of each chip area (representing the position of each chip area) are stored in a memory of a main control system. Positions of four alignment marks of each chip area (defined by coordinates of the center thereof) are also stored in the memory of the main control system. Accordingly, the exposure apparatus was arranged to measure the position of each alignment mark according to the following movement sequence empirically seeming best, by executing the EGA.

Specifically, for example, when a measuring point of an alignment optical system is at a start point ST (x: 186.5, y: 155.5), an XY stage with a wafer mounted thereon moves so that a right upper alignment mark of a chip area closest to the start point ST (the chip area 64 in Fig. 2) comes to the measuring point of the alignment optical system (so as to be in the measuring area). After completion of the position measurement of the alignment mark, the XY stage moves so as to measure the positions of the four alignment marks counterclockwise. Next, the XY stage moves so as to measure coordinates of the right upper alignment mark of a chip area closest clockwise (the chip area 63 in Fig. 1). After that, the XY stage moves so as to measure coordinates of the four alignment marks counterclockwise. Repeating this operation, the XY stage moves to measure the positions of the alignment marks of the all chip areas selected and return the measuring point of the alignment optical system to the end point EN (x: 215, y: 133). In Figs. 1 and 2, though all chip areas to be measured are adjacent to each other, for example, the alignment marks in the chip area 15 may be measured after measuring the alignment marks in the ship area 12 when the chip areas 13 and 14 are set as a chip area not to be measured. Of course, such controls of movement were also employed that the XY stage moved so as to measure the positions of the alignment marks of each chip area clockwise and that after completion of the position measurement of the all alignment marks of a chip area, the XY stage moved so as to measure the alignment marks of a chip area closest counterclockwise.

However, the movement sequence of the XY stage in the position measurement of each alignment mark was determined empirically as described above, and no consideration was given to efficient movement control of the XY stage for the position measurement of each alignment mark.

The reason is that there arises the following problem in obtaining the movement sequence of the XY stage for the position measurement of alignment marks using the statistical measurement process such as the EGA. For example, where there are n alignment marks to be measured on the wafer, the number of conceivable stage movements for movement between alignment marks is at most $_nP_2 = n(n - 1)$ (even though the turnaround tile differs depending upon the positive or negative movement direction of the stage) and computation thereof can be done quickly. Therefore, the overall turnaround time is determined uniquely as soon as the measurement process order is determined. However, there are n! way as to the order for the measurement process of n alignment marks, and the computation time becomes too long when the all possible solutions are computed using the producing and checking method of the all conceivable orders. Particularly, if n > 13, the computation is practically impossible ("Practical Course; Invitation to Traveling-Salesman Problems I, II, III," Operations Research 39 (1994), No. 1: pp 25-31, No. 2: pp 91-96, No. 3: pp 156-162). Accordingly, the conventional alignment methods did not involve a step of finding the optimum movement sequence under practical operation conditions.

SUMMARY OF THE INVENTION

The present invention concerns a movement control of a stage with a wafer mounted thereon for measuring positions of plural measurement target areas (including alignment areas) provided on the wafer in a shorter time, in alignment between a photomask or a reticle (hereinafter referred to generally as "reticle") and each chip area on the wafer, and more particularly, the invention relates to a determining method of movement sequence and an alignment apparatus to minimize the overall turnaround time of the stage movement associated with the sequential measurement process.

The inventors examined the conventional alignment technology described above and found the following issues.

First, the determining method of movement sequence in the measurement process carried out for alignment must obtain an optimum solution or a near-optimum solution to the permutation optimization problem within a shorter computation time. As described above, in the case of the movement sequence of the stage, an ideal process is to produce all possible measurement orders (movement sequences) of alignment mark positions and to find the shortest turnaround time (the overall movement time excluding the measurement times) as an optimum solution out of these candidates generated. However, when examination is made as to the order of measurement of the wafer having n alignment marks, n! paths must be checked only for the order of measurement of positions of the n alignment marks on the wafer. Especially, if n > 13, the computation time will become so enormous that it is practically impossible to obtain a solution. Therefore, in order to increase the throughput of the EGA, it is necessary to obtain the optimum solution or the near-optimum solution of the movement sequence of measurement process more efficiently.

Second, the determination of movement sequence of measurement process needs to take account of the tradeoff between the permissible computation time for obtaining the optimum solution or the near-optimum solution and the quality of the obtained solution. Specifically, the computation far obtaining the optimum solution of the movement sequence for the position measurement of alignment marks is carried out on the occasion of exchange of reticles of different exposure patterns or on the occasion of exchange of wafers from the reason that positions for the measurement process are designated arbitrarily wafer by wafer, even though they have a common exposure pattern. Therefore, permissible computation times vary depending upon the circumstances. For example, the time for exchange of reticles and alignment of the reticle (the reticle loading time) is normally 20 sec or so. The time for loading a first wafer in a certain lot (the water loading time) is normally 5 sec or so.

An object of the present invention is, therefore, to provide a determining method of movement sequence for obtaining a solution of a preferable movement sequence within a short time and an alignment apparatus provided with an arithmetic unit for carrying out the determining method. The determining method of movement sequence according to the present invention is a method to increase the throughput of EGA, in which a near-optimum solution of the movement sequence is first obtained within a very short computation time, then solutions of movement sequences to make shorter the movement time for the measurement process of alignment mark positions are successively produced as long as the computation time allows, and the optimum solution of the movement sequence is generated finally (if the sufficient, permissible computation time is given). This can provide a solution in a quality consistent with the permissible computation time given (the better the longer the permissible computation time), depending upon the circumstances of computational resources that can be used.

The determining method of movement sequence according to the present invention is carried out prior to an alignment step of performing alignment between a transfer position of a pattern of an original plate (a mask or a reticle) and each chip area on a substrate (wafer), the alignment step being a step of measuring positions of measurement target areas while successively moving the measurement target areas (alignment marks) on the substrate into a measuring area of a measuring system (an alignment optical system). The method according to the present invention determines the movement sequence indicating the measurement order of the alignment marks within a shorter time, thereby drastically increasing the throughput of the EGA.

Specifically, the determining method of movement sequence according to the present invention comprises an arithmetic step of obtaining a solution of a most preferable movement sequence with respect to an overall movement time between the measurement target areas by use of a predetermined search technique. This arithmetic step includes at least a first step of generating a group including a plurality of executable movement sequencies out of a group of movement sequence candidates each indicating a measurement order of plural measurement target areas, and a second step of selecting a movement sequence that completes the movement operation between the plural target areas within the shortest time out of the group thus generated.

Further, the determining method of movement sequence according to the present invention comprises a pre-step executed prior to the above arithmetic step, the pre-step being a step of producing a movement time management table in which for each of the plural measurement target areas, a movement time is recorded as a time necessary for movement of the target area of interest from a position thereof at the time of completion of position measurement of either one of the plural measurement target areas into the measuring area of the measuring system. This movement time management table also includes such information that for a pair of measurement target areas selected out of the plurality of measurement target areas, after completion of the position measurement of one measurement target area selected, the other measurement target area selected is prohibited from moving from a position thereof at the time of completion of the position measurement of the one measurement target area into the measuring area of the measuring system.

Particularly, the search technique executed in the above arithmetic step includes at least one of a method based on operations-research technique, a genetic algorithm (hereinafter referred to as GA) as an evolutionary computation method, and a combination thereof. The method based on operations-research technique includes at least one of a linear programming method, a Lin and Kernighan's approach (hereinafter referred to as LK method), and a k-OPT method.

The above GA can include as a genetic operator a search technique like an improving method such as the above method based on operations-research technique (the linear programming method (NN Method), the LK method (S. Lin and B. W. Kernighan, An Effective Heuristic Algorithm for the Traveling Salesman Problem, Operations Research 21 (1973) pp 498-516), or the k-OPT method (including the 2-OPT method and 3-OPT method) ("Practical Course: Invitation to the Traveling-Salesman Problems I, II, III," Operations Research 39 (1994) No. 1: pp 25-31, No. 2: pp 91-96, No. 3: pp 156-162). By this, a solution of a most preferable movement sequence out of solutions found at that time can be always obtained even on the way of computation for seeking the movement sequence. If a further computation time is given, a solution of a more preferable movement sequence can be obtained. Therefore, according to the present invention, a good solution of a movement sequence consistent with the computation time permitted can be obtained even if the computation is interrupted or even if a limitation is preliminarily imposed on the computation time.

On the other hand, the alignment apparatus according to the present invention comprises at least a measuring device (measuring system) for measuring each of positions of plural alignment marks, a moving device for effecting relative movement between the plural alignment marks and a measuring area of the measuring device, an arithmetic section for carrying out the above-stated determining method of movement sequence, and a control section for controlling the moving device so as to move the plural alignment marks successively into the measuring area of the measuring device, according to a solution of a movement sequence obtained by the arithmetic section.

Further, the alignment apparatus according to the present invention comprises a memory for storing a movement time management table in which for each of the plural alignment marks a movement time is recorded as a time necessary for movement of the alignment mark of interest from a position thereof at the time of completion of position measurement of either one of the plural alignment marks into the measuring area of the measuring device. The movement time management table stored in this memory also includes such information that for a pair of alignment marks selected out of the plural alignment marks, after completion of the position measurement of one alignment mark selected, the other alignment mark selected is prohibited from moving from a position thereof at the time of completion of the position measurement of the one alignment mark into the measuring area of the measuring device.

The GA applied as the above search technique is used, for example, as an approach for the case to find the shortest-length path in visiting each city only once and all cities, but there has been and is no example of application to optimization of the movement sequence for the position measurement of alignment marks in the steppers or the like,

As described above, in the present invention, the computation of optimization (how efficiently the XY stage is moved) of the movement sequence for the position measurement by the search technique (the linear programming method, the LK method, the k-OPT method, or the GA) is carried out prior to the measurement of the positions of plural alignment marks. Based on the computation result, the alignment apparatus according to the present invention operates to move the XY stage so as to bring each of the alignment marks into the measuring area of the alignment optical system. Then the position of each alignment mark is measured by the alignment optical system.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

## BRIEF DESCRIPTION OF THE DRAWINGS

Fig. 1 is a drawing to show a solution of a movement sequence (the first example) obtained by the conventional approach based on the rule of thumb;

Fig. 2 is a drawing to show a solution of a movement sequence (the second example) obtained by the conventional approach based on the rule of thumb;

Fig. 3 is a drawing to show the overall structure of the projection exposure apparatus (stepper) including the alignment apparatus provided with the arithmetic section for realizing the determining method of movement sequence according to the present invention;

Fig. 4 is a flowchart for explaining the measurement process of alignment mark position for the EGA arithmetic;

Fig. 5 is a table to show the performance of the wafer stage etc.;

Fig. 6 is a table to show chip areas positions of which are to be measured, and coordinates of their centers (representing the positions of the chip areas);

Fig. 7 is a table to show a movement time management table;

Fig. 8 is a drawing to show locations of chip areas and alignment marks provided on a wafer;

Fig. 9 is a drawing to show a first arrangement example of alignment marks in a chip area;

Fig. 10 is a drawing to show a second arrangement example of alignment marks in a chip area;

Fig. 11 is a diagram to show an example of flowchart for explaining an example of the genetic algorithm applied as a search technique of movement sequence;

Fig. 12 is a diagram to show an example of flowchart for explaining another example of the genetic algorithm applied as a search technique of movement sequence;

Fig. 13 is a drawing for explaining a crossover operator in the genetic algorithm;

Fig. 14 is a drawing for explaining a mutation operator (cyclic shift) in the genetic algorithm;

Fig. 15 is a drawing to show a solution of a movement sequence obtained by the determining method of movement sequence according to the present invention;

Fig. 16 is a drawing to show a solution of a movement sequence obtained by the determining method of movement sequence according to the present invention, to which the linear programming method (NN method) is applied;

Fig. 17 is a flowchart for explaining the determining method of movement sequence according to the present invention, to which the NN method is applied;

Fig. 18 is a drawing to show a solution of a movement sequence obtained by the determining method of movement sequence according to the present invention, to which the LK method utilizing initial solutions obtained by the NN method is applied;

Fig. 19 is a flowchart for explaining the determining method of movement sequence according to the present invention, to which the LK method is applied;

Fig. 20 is a drawing to show the relation between the computation time of the approach based on the rule of thumb, the NN method, and the LK method, and the overall movement time of the movement sequences obtained thereby;

Fig. 21 is a drawing to show the relation between the computation time of the GA using randomly generated feasible base solutions as an initial group and the overall movement time of the movement sequence obtained; and

Fig. 22 is a drawing to show the relation between the computation time of the GA using plural solutions obtained by the NN method + the LK method as an initial group and the overall movement time of the movement sequence obtained thereby.

## DETAILED DESCRIPTION OF THE PREFERRED EMBODIMENTS

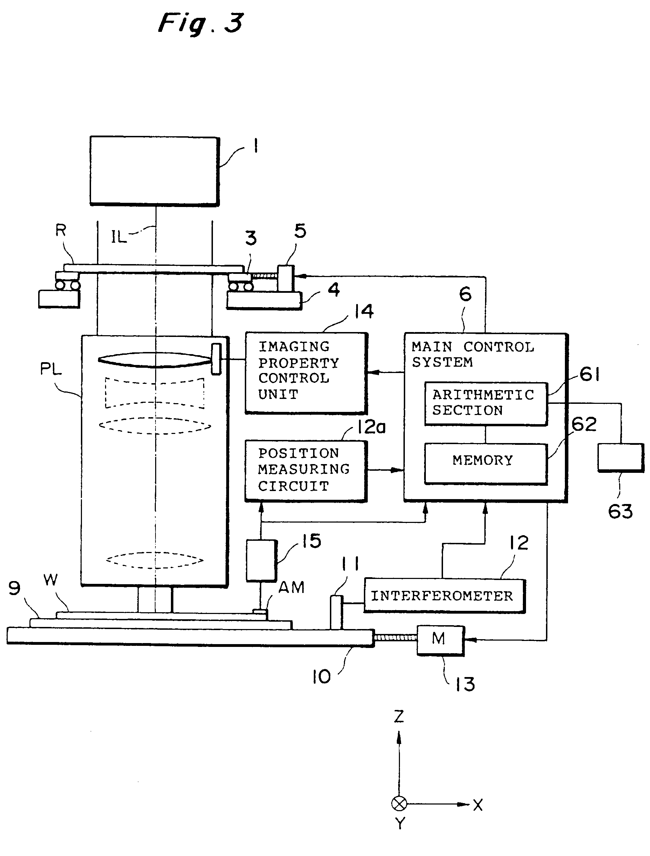

The embodiments of the determining method of movement sequence and alignment apparatus according to the present invention will be described using Fig. 3 to Fig. 22. The embodiments are examples to find the optimum movement sequence indicating the order of measurement of alignment mark positions in the EGA (Enhanced Global Alignment: alignment by the statistical arithmetic method) in the step-and-repeat type (one-shot type) projection exposure apparatus. It should be noted that the present invention can also be applied to the step-and-scan type exposure apparatus for synchronously scanning the reticle relative to the wafer.

Fig. 3 shows the structure of a projection exposure apparatus (stepper). In this Fig. 3 the reticle R is illuminated under almost uniform illuminance by exposure light IL emitted from illumination optical system 1. The reticle R is held on reticle stage 3 and the reticle stage 3 is supported so as to be movable and finely rotatable in a two-dimensional plane on base 4. Main control system 6 for controlling the operation of the whole apparatus controls the operation of the reticle stage 3 through driving device 5 provided on the base 4.

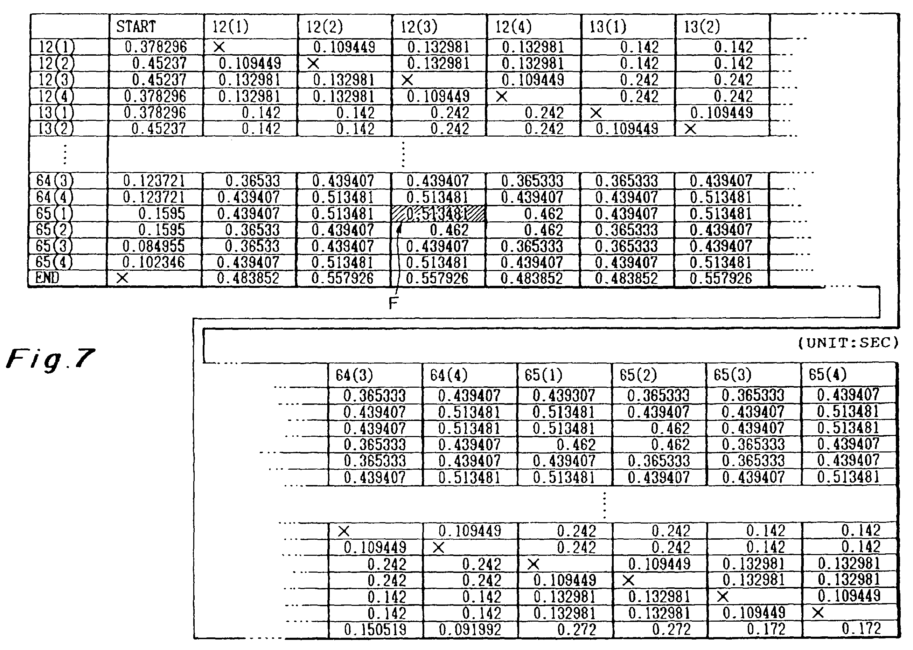

The above main control system 6 has an arithmetic section 61 for carrying out the determining method of movement sequence according to the present invention and a memory 62 in which a movement time management table (see Fig. 7) is stored. This main control system 6 receives instructions from the operator or the like through input device 63 such as a keyboard or a pointing device.

An image of a pattern of the reticle R illuminated by the exposure light IL is projected through a projection optical system PL onto each chip area on the wafer W. The wafer W is mounted on wafer stage 10 through water holder 9. The wafer stage 10 is composed of an XY stage for two-dimensionally positioning the wafer W on a plane normal to the optic axis of the projection optical system PL, a Z-stage for positioning the wafer W in a direction (Z-direction) parallel to the optic axis of the projection optical System PL, a stage for finely rotating the wafer W, and other components.

A moving mirror 11 is fixed on the top surface of the wafer stage 10 and a laser interferometer 12 is positioned opposite to the moving mirror 11. Although the moving mirror 11 is illustrated in a simplified form in Fig. 3, where the orthogonal coordinate system is defined with the X-axis and Y-axis in the plane normal to the optic axis of the projection optical system PL, the moving mirror 11 is composed of a plane mirror having a reflective surface normal to the X-axis and a plane mirror having a reflective surface normal to the Y-axis. The laser interferometer 12 is composed of two X-axis laser interferometers for emitting a laser beam to the moving mirror 11 along the X-axis and a Y-axis laser interferometer for emitting a laser beam to the moving mirror 11 along the Y-axis, and the one X-axis laser interferometer and one Y-axis laser interferometer measure X-coordinate and Y-coordinate of the wafer stage 10.

An angle of rotation of the wafer stage 10 is measured from a difference between measured values by the two X-axis laser interferometers. The information about the X-coordinate, Y-coordinate, and angle of rotation measured by the laser interferometer 12 is supplied to position measuring circuit 12a and to the main control system 6. The main control system 6 controls the positioning operation of the wafer stage 10 through driving device (linear motor M) 13 while monitoring the coordinate data supplied. The same interferometer system as on the wafer side is also provided on the reticle side, though not illustrated in Fig. 3.

Further, the projection optical system PL of Fig. 3 is equipped with imaging property controlling device 14. The imaging property controlling device 14 controls the projection magnification and distortion of the projection optical system PL, for example, by adjusting a space between predetermined lenses out of a group of lenses composing the projection optical system PL or by adjusting the pressure inside the lens chamber between predetermined lenses. The main control system 6 also controls the operation of the imaging property controlling device 14.

This embodiment uses an off-axis alignment optical system of an image processing type as a method for obtaining a position of an alignment mark (coordinates of the center thereof). However, the position of the alignment mark can also be obtained by receiving diffracted light by the alignment optical system of the TTL (through the lens) type.

The off-axis alignment optical system (device) 15 is placed beside the projection optical system PL of Fig. 3. This alignment system 15 forms an image of a cross alignment mark AM on an image pickup surface of an X-axis image pickup device composed of a two-dimensional CCD for the X-axis and also forms the image on an image pickup surface of a Y-axis image pickup device composed of a two-dimensional CCD for the Y-axis. The image of the alignment mark AM and an image of an index mark provided on an index screen (not illustrated) are superimposed on each of the image pickup surfaces of the image pickup devices. Image signals of the image pickup devices are supplied to the position measuring circuit 12a, which calculates amounts of positional deviation in the X-axis direction and in the Y-axis direction between the image of the alignment mark AM and the image of the index mark.

Accordingly, in Fig. 3, the position measuring circuit 12a obtains coordinates of the alignment mark AM on the stage coordinate system (X, Y) from the positional relation between the image of the alignment mark AM on the wafer W and the index mark on the index screen and the measurement results of the laser interferometer 12 in that case, and supplies the coordinate data thus measured to the main control system 6.

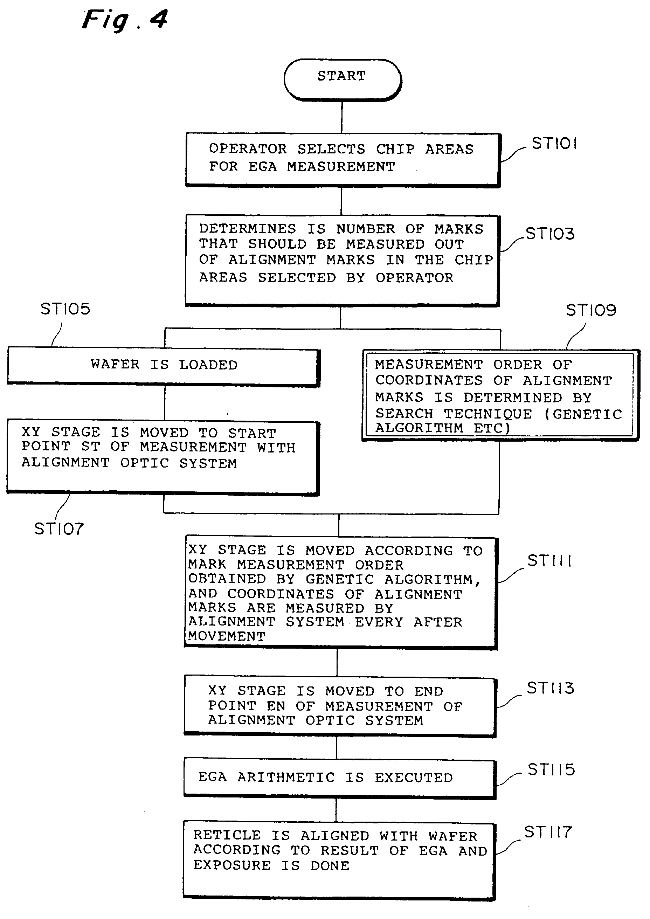

Fig. 4 is a flowchart for explaining the position measurement of alignment mark for the EGA arithmetic being the statistical arithmetic method. The movement control of the XY stage for the position measurement of alignment mark will be described along this flowchart.

First, the operator selects a plurality of chip areas for the EGA measurement from the all chip areas in the wafer W and the data is supplied to the main control system 6 (step ST101). The operator is allowed to select the all chip areas.

Then the operator determines which or how many marks should be measured out of the plural alignment marks AM mainly provided in the peripheral region of each chip area, and the information it supplied to the main control system 6 (step ST103). In this embodiment there are four cross alignment marks AM (which permit two-dimensional coordinate measurement) positioned per each chip area.

The present invention permits use of an arrangement in which two alignment marks AM are positioned per each chip area or an arrangement of a linear alignment mark AM (permitting one-dimensional coordinate measurement) for each chip area. It is necessary to obtain coordinates of ten alignment marks AM on a one-dimensional basis, in order to obtain (1) residual rotation error $\Theta$ of the wafer, (2) orthogonality error W of the stage coordinate system (or shot arrangement), (3) linear expansion or contraction Rx, Ry of the wafer, (4) offset (translation) OX, OY of the wafer (the center position), (5) residual rotation error $\theta$ of the circuit pattern (chip pattern) on each shot area of the wafer, (6) orthogonality error w of the coordinate system (chip pattern) on the wafer, and (7) linear expansion or contraction rx, ry in two orthogonal directions of the chip pattern (see Japanese Laid-open Patent Application No. Hei 6-275496).

Next, the main control system 6 sends a command to a loader (not illustrated) to make the loader mount (or load) the wafer W to be exposed on the wafer holder 9 (step ST105). In this case, the XY stage 10 moves to a predetermined mount position for receiving the wafer W.

After the wafer W is mounted on the wafer holder 9 to he sucked by vacuum, the main control system 6 moves the XY stage 10 so as to locate the measuring point (representing the measuring area) of the alignment optical system 15 at the start point ST, for carrying out the EGA (step ST107).

In the main control system 6, almost at the same time as the arithmetic section 61 sends the load command of wafer W described above, the arithmetic section 61 starts finding a sequence of a short time indicating a measurement order of the chip areas and alignment marks AM given in steps ST101 and ST103 by a search technique (a linear programming method, a Lin and Kernighan's approach, a K-Opt method, or a genetic algorithm) (step ST 109). The arithmetic executed in this arithmetic section 61 will be described hereinafter. Designed center coordinates of the respective chip areas and designed coordinates of the respective alignment marks AM are preliminarily recorded in the memory 63 in the main control system 6.

Next, in step ST111, the main control system 6 moves the XY stage according to the measurement order of the alignment marks AM obtained by the genetic algorithm in the arithmetic section 61. A position of each alignment mark AM is measured by the alignment optical system, whereby an amount of positional deviation thereof is measured relative to the index mark. At this time values of the laser interferometer 12 are also read, whereby coordinates of the alignment mark AM are obtained on the stage coordinate system (X, Y) by the position measuring circuit 12a. The coordinate values measured are supplied to the main control system 6.

At the time of completion of the measurement of positions of the all alignment marks as being measurement targets, the main control system 6 moves the XY stage so as to move the measuring point of the alignment optical system 15 to the end point EN (step ST113).

The arithmetic section of the main control system 6 further performs the EGA arithmetic, based on the information about the positions of the plural alignment marks measured, thereby obtaining the error parameters, expansion or contraction of the water, rotation of each chip area, etc. (step ST115).

Then the main control system 6 moves the XY stage 10 to coordinates of each chip area to be exposed, according to the computation result of EGA or compensates for expansion or contraction of chip area or the like by the imaging property controlling device 14, and then performs exposure (step ST117).

Next described is the optimization of movement sequence for the position measurement of alignment marks. A path (order) of the position measurement of alignment marks is obtained in the arithmetic section 61 in the main control system 6, and preconditions necessary for the arithmetic will be described first.

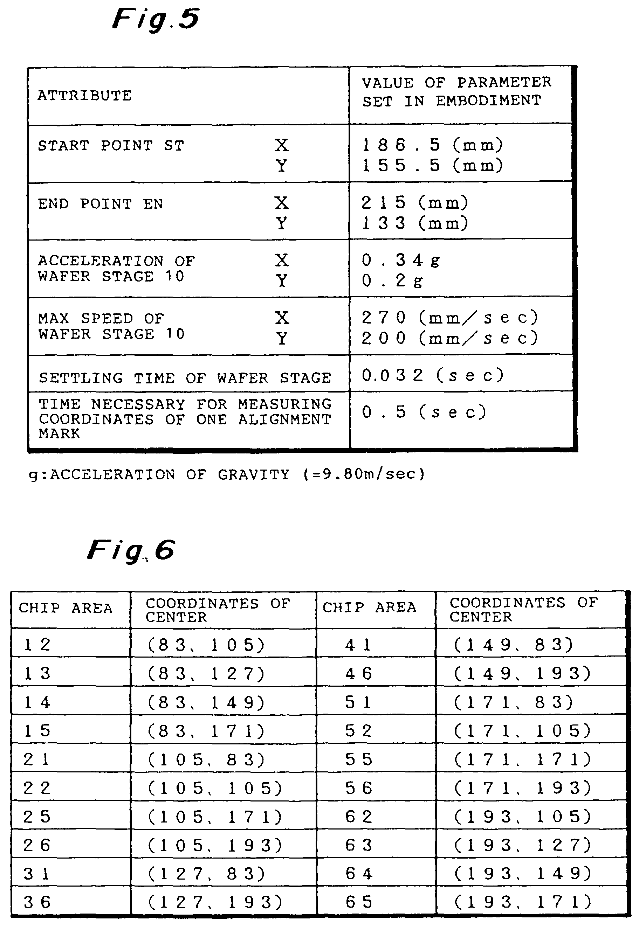

Fig. 5 to Fig. 10 are drawings to illustrate the preconditions necessary for obtaining the movement sequence for the position measurement of alignment marks, in order to compare the effect of the present invention with the conventional technology. Of course, this is just an example, and it should be noted that the conditions including the size of chip area, the number of chips, the positions of alignment marks, the number of alignment marks, and so on can be changed freely.

Fig. 5 shows data of the stepper used in the present embodiment, including the start point ST and end point EN of the wafer stage 10.

Accelerations and maximum speeds of movement of the wafer stage 10 are as shown in Fig. 5, because the time of movement in the X-direction is different from that in the Y-direction because of the difference between the weights of the Y-stage, mechanisms, and so on.

In this embodiment, the time necessary for measurement of a position of one alignment mark is set to 0.5 sec, as shown in Fig. 5.

Fig. 6 shows coordinates of centers of twenty chips (X, Y in units of mm) denoted by numerals 12, 13, 14, 15, 21, 22, 25, 26, 31, 36, 41, 46, 51, 52, 55, 56, 62, 63, 64, 65 in the coordinate system on the wafer, and the twenty chip areas are those measured in this embodiment.

Fig. 7 is a drawing to show the movement time management table preliminarily stored in the memory 62. From this movement time management table, moving times between alignment marks are found where four alignment marks are provided for each of the twenty chip areas being measurement targets. For example, in this movement time management table, the time indicated by F in the drawing represents a time necessary for the third alignment mark in the chip area 12 on the wafer W to move from a position thereof at the time of completion of the measurement of the position of the second alignment mark of the chip area 65 on the wafer W to the measuring point of the alignment optical system 15. This movement time management table also includes movement prohibition information for indicating prohibited movement. This movement prohibition information is indicated by symbol "X" in the drawing.

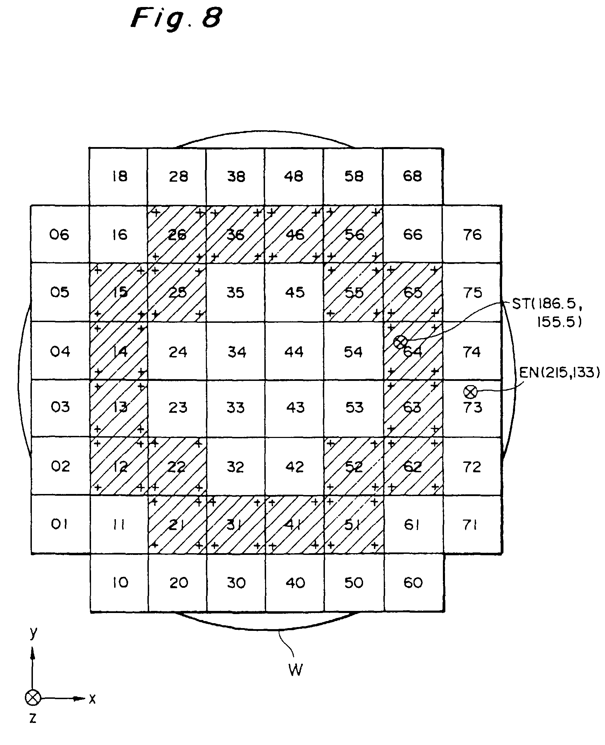

Fig. 8 is a drawing to show an arrangement of the chip areas on the wafer. Particularly, the chip areas indicated by hatching are those where the position measurement of the alignment marks specified in Fig. 6 is carried out. The size of each chip area is 22 mm (in the X-direction) × 22 mm (in the Y-direction). Distances between centers of chip areas are 22 mm in the X-direction and 22 mm in the Y-direction.

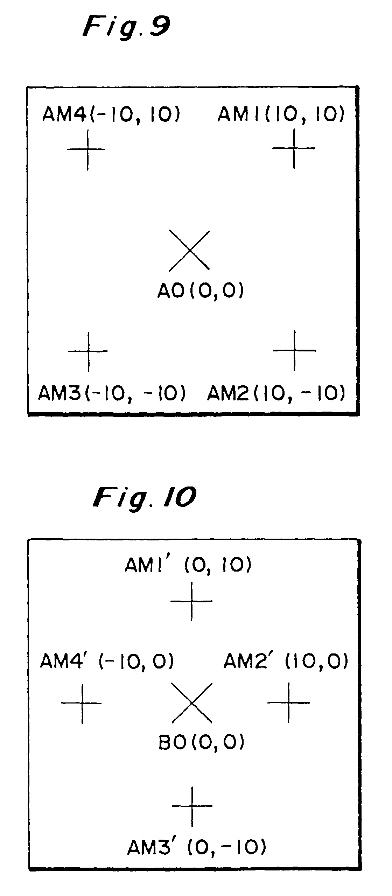

Next, Fig. 9 shows cross alignment marks AM disposed in each chip area to be a measured object. In this embodiment there are four alignment marks AM1 to AM4 in each chip area as a measured object. When the center coordinates A0 of the chip area are defined by (0, 0), the Position measurement of the alignment marks in the chip area is set to be carried out in the order of AM1 (10, 10), AM2 (10, -10), AM 3 (-10, -10), and AM4 (-10, 10). Of course, this is just an example, and the alignment marks Am 1' to AM4' can be positioned as shown in Fig. 10 on the chip area.

The position measurement of the alignment marks is started after the wafer stage 10 has been moved so that the optic axis of the alignment optical system 15 (or the measuring point on the wafer W by the alignment optical system 15) was aligned with the start point ST (X = 186.5, Y = 155.5). The position measurement is terminated at the time of arrival of the optic axis of the alignment optical system 15 (the measuring point on the wafer) at the end point EN (X = 215, Y =133).

Since the measurement time at each alignment mark AM is constant, the optimization of movement sequence means eliminating waste movement time from the movement sequence as much as possible. Let us consider a time from a point of completion of the position measurement at an arbitrary alignment mark AM (a start point of a unit movement sequence) to a point of start of the measurement process at another arbitrary alignment mark AM (an end point of the unit movement sequence). In the case where there are n alignment marks AM, the number of cases of arbitrary unit movement sequences is at most $n \times (n - 1)$. Since the shortest movement times of the respective unit movement sequences are uniquely determined from the aforementioned preconditions, these are computed first and the movement time management table obtained (see Fig. 7) is stored in the memory 62. After completion of the operation up to this point, the optimum movement sequence can be obtained by optimization of selection and order to determine which unit movement sequences should be selected out of the unit movement sequences and used in what order (in the sense of minimizing the final measurement process sequence of coordinates of alignment marks AM). Accordingly, to minimize the overall movement time of the movement sequence means to optimize the movement sequence for the position measurement of alignment marks AM, which is an object of the present invention. This method will be described below.

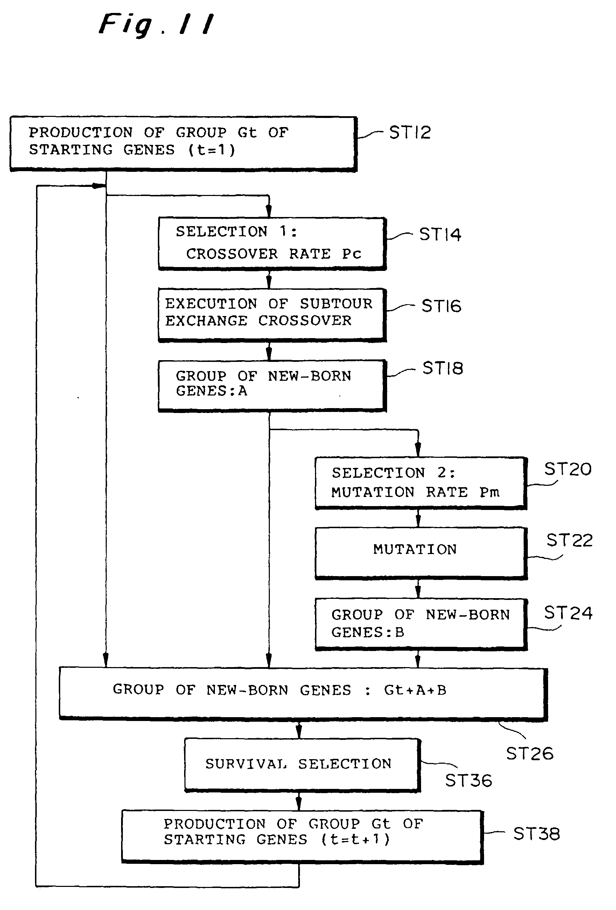

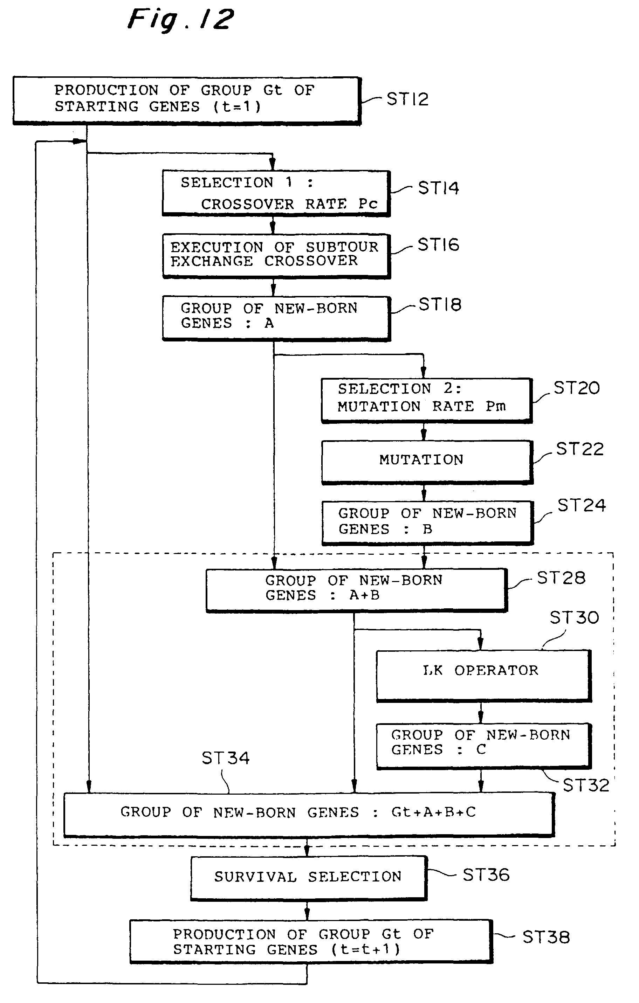

This embodiment is arranged to automatically obtain the optimum solution of the order (movement sequence) of position measurement of alignment marks (a solution of a movement sequence to minimize the overall movement time), using the genetic algorithm (GA: Genetic Algorithm), which is a typical example of the evolutionary computation method. Fig. 11 and Fig. 12 illustrate examples of the operation of the genetic algorithm.

The name of the GA was given, because individual operations thereof could be compared to genes, as will be described below.

An initial solution in the GA is arbitrary. Accordingly, the genetic algorithm can be readily combined with another search method and it is also easy to incorporate only an advantage of another search method into a genetic operator. Therefore, proper analysis of problem and programmer's experiences in evolutionary computation are required to achieve an efficient approach with high degrees of freedom of design.

The GA of this embodiment can be classified roughly into GA as a combinatorial optimization approach placing the main point on crossover, ES (Evolutional Strategy) as a continuous value optimization approach placing the main point on mutation, and, different in classification from these, GP (Genetic Programming) directed to the source and process procedures of program, but the essence of the all algorithms is identical.

In the GA, a group search is carried out with plural (N) agents called "genes," and the GA thus has such a property that even if a part of the group falls into a local optimum solution but if the other gene finds a better solution the search is led to the better solution. Since it is a multipoint search, it takes some time, but can efficiently search the optimum solution. A plurality of pairs (parents) are selected from the gene group consisting of the N genes and each of the gene pairs P bears children C resembling their parents. Further, some children C experience mutation in part of gene. Among these genes, descendents having genes with higher evaluation are made to survive with higher probability in the next generation. Since the size of the group is normally fixed to N throughout generations except for special cases, descendants having genes with lower evaluation will gradually become extinct. Repetition of such alteration of generation will find plural (N) genes with the optimum solution appearing in the group sooner or later.

This embodiment adopts the Subtour Exchange Crossover (SXX) famous as an approach by GA in order to improve the movement sequence. In this way the optimization problem of movement sequence for the position measurement of alignment marks in the stepper is formulated by the GA. Examples of models for the alteration of generation used in the GA include the MGG (Minimum Generation Gap) model in which the all genes are paired without any unmarried person and best two genes out of each family including a pair and children born are left to the next generation (H. Satoh, M. Yamamura and S. Kobayashi, Minimum Generation Gap Model for GAs Considering Both Exploration and Exploitation, Proceedings of IIZUKA '96, pp. 494-497), and the Elitist model in which good people out of the all parents and children are left preferentially (D. E. Goldberg, Genetic Algorithm in Search, Optimization and Machine Learning, Addison-Wesley Publishing Company Inc., 1989). The MGG model is used if the true optimum solution is desired to obtain finally even with some computation time; whereas the Elitist model is used if a good solution can be found in the early stage of the computation process and even if a computation time longer than that in the MGG model is necessary for obtaining the true optimum solution. Thus, they can be used selectively based on how to make the trade-off between the computation time and the quality of solution. In this embodiment, an example using the Elitist model will be described as an example of such selective use.

Before describing the GA shown in the flowcharts of Fig. 11 and Fig. 12 in detail, each of operators shown in the algorithms will be described first.

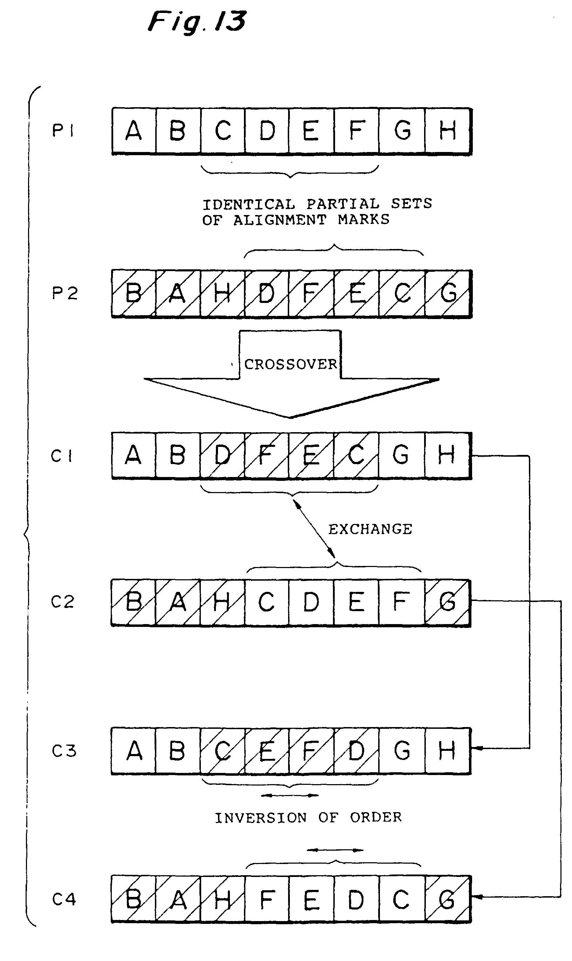

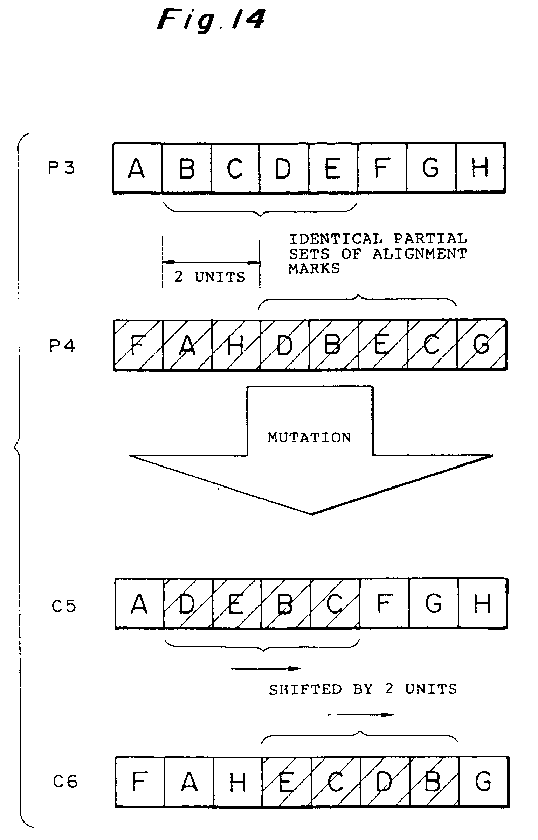

In Fig. 13 and Fig. 14 P1, P2, C1, C2, etc. represent measurement orders of alignment mark positions, imitating the genes. One unit is defined as a position of one measurement of an alignment mark. One gene is expressed by a string of n units corresponding to n alignment marks. Since in this embodiment the number of chip areas position-measured is 20 and the number of alignment marks in each chip area is 4, one gene is composed of $20 \times 4 = 80$ units. For simplification of description, the description will be given as to an example in which eight alignment marks are measured and denoted by A to H. Namely, each operator will be explained using an example in which one gene is composed of eight units.

Fig. 13 is a drawing to illustrate a crossover operator for subtour exchange crossover, which is one of the genetic operators. The concept of the crossover operator is to make from two parents two or more children having characteristics of the both parents. The subtour exchange crossover operator is applied to a pair of genes P1 and P2 randomly selected out of plural genes. At this time the crossover operator searches portions having a common partial set of alignment marks in the genes P1 and P2. The third unit to the sixth unit of the gene P1 are a set of alignment marks C, D, E, and F. Further, the fourth unit to the seventh unit of the gene P2 are also a set of alignment marks C, D, E, and F.

These common portions (subtours) are exchanged between the gene P1 and the gene P2. Namely, new genes of C1 and C2 are generated. In this embodiment genes C3 and C4 are further generated by inversion of the partial information of the exchanged portions from the genes C1 and C2. Namely, the two parents have four children.

Fig. 14 is a drawing to illustrate a mutation operator, which is one of the genetic operators. The concept of the mutation operator is to generate children having characteristics that their parents do not have. Fig. 14 illustrates the mutation operator, particularly, for improvement in the movement order of object (the order of position measurement of alignment marks: cyclic shift). The mutation operator is applied to a pair of genes P3 and P4 randomly selected out of plural genes. This mutation operator first searches portions having a common partial set of alignment marks in the genes P3 and P4. In Fig. 14, the second unit to the fifth unit of the gene P3 are a set of alignment marks B, C, D, and E, while the fourth unit to the seventh unit of the gene P4 are a set of alignment marks B, C, D, and E. Thus, the two sets are identical.

A difference of units between such partial strings appearing in the genes P3 and P4 is defined as a number of shifts. In Fig. 14 the partial string starts from the second unit in the gene P3 while the partial string starts from the fourth unit in the gene P4; therefore, there is the difference of two units and thus the number of shifts is 2. Then the units appearing in the partial set of alignment marks are shifted in order and in cycle by the number of shifts, thus generating new genes C5 and C6. This means that the gene C5 is obtained in such a way that the partial set of BCDE in the gene P3 is shifted once to be CDEB and then it is shifted once more to be DEBC. The gene C6 is also obtained in the same way.

The contents of each operator were detailed above and now, returning to the flowcharts of Fig. 11 and Fig. 12, the procedures of application of each operator will be described.

First, genes of a gene group consisting of genes numbering N preliminarily set (for example, N = 80) are generated randomly (step ST12). Each gene in this group is determined as one for measuring each of the all positions of the alignment marks numbering n (for example, n = 80) once. Each of the genes can be a solution generated (or updated) by an approach based on the rule of thumb, an approach based on the linear programming method (for example, the nearest neighbor method which will be called the NN method and the details of which will be described hereinafter, or the like), or the Lin and Kernighan's approach (hereinafter referred to as the LK method the details of which will be described hereinafter) with an initial solution being a constraint satisfying solution generated arbitrarily; or a solution generated (or updated) by the LK method with an initial solution being a constraint satisfying solution generated by the approach based on the linear programming method (for example, the NN method or the like). Since the generation t at this time is t = 1, the gene group of the first generation will be called G1. The overall movement times of movement sequences are computed for the position measurement of alignment marks of individual genes in the gene group G1 of the first generation. For example, the overall movement times are 64.278 sec for the first gene, 63.448 sec for the second gene,..., 56.163 sec for the twenty fifth gene, and 53.046 sec for the twenty sixth gene.

In one alteration of generation, first, the crossover is carried out in the number of crossovers according to a crossover rate preliminarily set (Pc = 0.4): $N \times Pc$ times ($80 \times 0.4 = 32$ times) out of the group of the N (= 80) genes. A pair of (two) genes as objects of one crossover are sampled without replacement (or without permitting crossover of a same gene) preferentially from the shortest measurement time out of the gene group. This selection of the paired genes is carried out the number of crossovers times by sampling with replacement (permitting one gene to be selected plural times for different pairs) out of the gene group. One of specific, applicable methods for preferentially selecting the genes of short measurement time is the roulette wheel selection, which will be described in step ST36. Another applicable method is a method for selecting $N \times Pc \times 2$ genes in order from the shortest overall movement time of movement sequence out of the gene group and randomly selecting pairs of $N \times Pc$ genes therefrom.

When the crossover operator is applied to each of these gene pairs (step ST16), new genes numbering $N \times Pc \times 2$ ($80 \times 0.4 \times 2 = 64$) are generated. This operator produces a group of new-born genes $A$ ($= N \times Pc \times 2$) (step ST18).

Next, the "mutation of ordinal shift of position measurement of alignment marks" is carried out $A \times Pm$ times ($64 \times 0.4 = 25.6$ times: which is raised to an integer, 26) according to the rate of "mutation of ordinal shift of position measurement of alignment marks" preliminarily set ($Pm = 0.4$) out of these new-born genes. Selection of one gene as an object of one "mutation of ordinal shift of position measurement of alignment marks" is carried out by random sampling with replacement (permitting one gene to be selected as a mutation object plural times) out of the gene group (step ST20: selection 2). When the "mutation operator of ordinal shift of position measurement of alignment marks" is applied to the totally twenty six genes selected (step ST22), new genes numbering $A \times Pm$ (twenty six genes) are generated. This operator produces a group of new-born genes $B$ ($= A \times Pm = N \times Pc \times 2 \times Pm$) (step ST24).

By the process heretofore, there are the gene group G1 of the first generation ($N = 80$), the new-born gene group A (64), and the new-born gene group B (26). Totally, there are the genes numbering $N \times \{1 + 2 \times Pc \times (1 + Pm)\}$ (170 genes) (step ST26).

In the case of the GA in the flowchart shown in Fig. 11, the steps up to this point correspond to multiplication of new-born genes by the genetic operators. In the case of the GA in the flowchart shown in Fig. 12, multiplication by the LK operator detailed hereinafter is introduced immediately after this point.

After completion of multiplication of new-born genes in each generation (i.e., in one loop in the flowchart shown in Fig. 11 or Fig. 12), in the final step of the loop a survival process is carried out to select genes to be left as a gene group of the next generation (i.e., an initial gene group in the next loop) and to dismiss the other genes (step ST36). Namely, the movement times are checked for the all movement sequences corresponding to the individual genes included in the new-born gene group A and the new-born gene group B generated by the genetic operators (the new-horn gene group C is further added in the case of the GA in the flowchart shown in Fig. 12) in addition to the initial gene group Gt. Then the best gene, which is a gene to achieve a movement sequence having the shortest movement time among them, is outputted. At this time, if S different genes all are the best, these S genes are left unconditionally in the next generation. Further, ($N - S$) genes are also selected out of the remaining (170 - S) genes by such a selecting method as to select a gene corresponding to a movement sequence of a shorter movement time more preferentially. These genes are also left in the next generation (i.e., in the ($t + 1$)-th generation). Namely, the survival process is carried out so as to select totally N genes including those of the movement sequences of the shortest movement time and the other genes (step ST36). This selection method is not one for selecting N movement sequences from the shortest movement time, but is one for selecting epistatic movement sequences with a higher priority but still leaving a possibility of selecting even a hypostatic movement sequence (of longer movement time), though low. The reason why the possibility of selecting a hypostatic movement sequence is left is that the true optimum solution is not always derived from a group of epistatic movement sequences, but is also possibly derived from a group of hypostatic movement sequences. Meanwhile, if a solution derived from a hypostatic movement sequence is also still hypostatic in the next generation, it will be naturally dismissed. Therefore, it will not be a hindrance against finding of the true optimum solution. The roulette wheel selection can be applied as a selection method of this type. For example, supposing in the optimization problem of movement sequence there are three candidates X, Y, Z as solutions of movement sequences and their movement times are 10 sec, 20 sec, and 20 sec, respectively, it is contemplated that the inverse of the time is set as a fitness value of each solution. At this time, supposing one solution is selected out of these three solutions by roulette wheel selection, probabilities of selection of the solutions X, Y, and Z are 0.5, 0.25, and 0.25, respectively. The eighty new genes thus selected compose a set of genes of the next generation, Gt+1. Then, returning to step ST14, the same process with the genetic operators is repeated.

As apparent from the algorithm to repeat this alteration of generation, for example, Supposing exchange of reticle takes 10 sec and within that period the computation is completed, for example, up to the fortieth generation, the shortest movement sequence for position measurement of alignment marks can be obtained among the group of genes (solutions) of the fortieth generation. Supposing exchange of reticle takes 11 sec and within that period the computation is completed up to the forty first generation, the shortest movement sequence for position measurement of alignment marks can be obtained among the group of genes (solutions) of the forty first generation.

Further, as shown in Fig. 12, the LK method can he incorporated as one of the genetic operators into the GA in order to obtain the optimum solution or the best solution more efficiently. In this case, the LK method (hereinafter referred to as an LK operator) is applied to plural genes (for example, to the all genes) in the gene group including the new-born genes obtained after the application of the crossover operator and mutation operator (step ST30). Thus, a new-born gene group C (the number of new-born genes included in C is $N \times 2 \times Pc \times (1 + Pm)$ ) is newly produced herein (step ST32). Namely, immediately before the survival, there exist the genes numbering $2 \times N \times 2 \times Pc \times (1 + Pm)$ (Step ST34). The preset crossover rate Pc, the preset mutation rate Pm, the GA, etc. are stored in the memory 62 of the main control system 6 (Fig. 3).

Since the above embodiment minimizes the overall movement time of the movement sequence for position measurement of alignment marks by applying the GA to the projection exposure apparatus, it makes possible scheduling of the order (path) of position measurement of each alignment mark.

The present embodiment also makes possible the optimization in which the local search by the crossover operator is merged with the global search by the mutation operator. In addition, since the best solution of each generation is presented every alteration of generation by the GA, a near-optimum solution consistent with a computation time can be outputted even with interruption of computation within the allowed computation time.

The crossover operator, SXX, in the present embodiment can be replaced by another crossover operator used in approaches to TSP, such as OX: Order crossover (L. Davis, "Applying Adaptive Algorithms to Epistatic Domains," Proceedings of International Joint Conference on Artificial Intelligence (IJCAI), 1985), PMX: Partially Mapped Crossover (D. E. Goldberg and R. Linge, "Alleles, Loci, and the Traveling Salesman Problem," Proceedings of International Conference on Genetic Algorithms (ICGA), 1985), or EAX: Edge Assembly Crossover (Nagata, Ono, and Kobayashi: "Proposal and evaluation of edge assembly crossover: New crossover of TSP considering tradeoff between character heredity and degree of freedom of crossover," System and Information Joint Symposium '96, Keisoku Jido Seigyo Gakkai, 1996).

Next described is the difference between the determining method of movement sequence according to the present invention and the conventional determining method of movement sequence. Specifically, for clearly expressing the difference between the solution of movement sequence obtained by the present invention (the result of execution of the determining method according to the present invention) and the solution of movement sequence obtained by the conventional technology (the result of execution of the conventional determining method), the following description shows the difference of measurement path in the serial movement sequence, i.e., the difference in a path of a locus drawn by measuring light on one wafer (a locus of the point where the measuring light arrives), and the difference in the overall movement time of movement sequence necessary for measuring positions of alignment marks on one wafer.

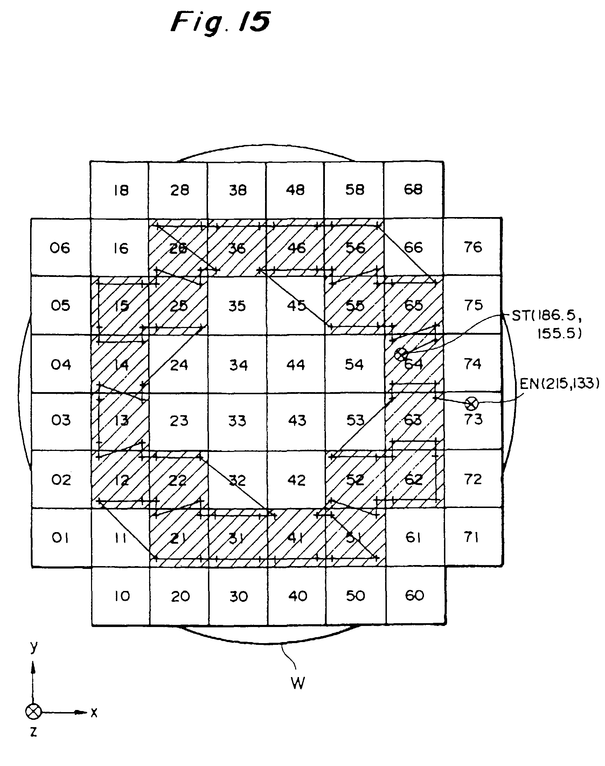

For guaranteeing the true optimum solution, all constraint satisfying solutions (feasible basic solutions) that can be generated must be checked and it requires enormous computational complexity, which is not practical. For examination, alterations of generation, which seemed sufficient to converge, were made in the GA using the MGG model under such preset conditions that the group size was somewhat large, the crossover rate was somewhat high, and the mutation rate was sufficiently high in comparison with the group size. When the alterations of generation were made with a sufficient time from an initial group generated at random, the convergent solution (the true optimum solution) was the movement sequence as shown in Fig. 15. The route passed the nearest alignment marks after or before the start point ST and the end point EN and there existed no seemingly long path. The overall movement time was 49.052 sec. After that, the convergent solution this time was handled as a substitute for the "true optimum solution." In this GA the computation was continued up to the 500th generation (for about thirty hours) under the setting conditions that the group size N was N = 160, the crossover rate Pc was Pc = 0.5, and the mutation rate Pm was Pm = 0.4. A solution regarded as the convergent solution first appeared near the 300th generation and approximately twenty hours were consumed up thereto. This GA can finally reach the optimum solution with the sufficient time consumed, but it is not practical to apply the GA as it is, Thus, the approaches by the GAs shown in Fig. 11 and Fig. 12 above involve some means to find the optimum solution quickly.

Fig. 1 and Fig. 2 show solutions of movement sequences for the position measurement of alignment marks being measurement targets, which were obtained by the prior-art determining method described previously. These movement sequences obtained by the prior-art approach are utilized from an empirical hope that they might not be the optimum solution, but may be satisfactorily good solutions. In the following description this approach is thus called "approach based on the rule of thumb."

When the approach based on the rule of thumb is applied, the operator determines the movement sequence that seems empirically good, according to the arrangement of chip areas to be measured. For example, a movement sequence obtained by the approach based on the rule of thumb is as follows. First, when the chip area 64 closest to the start point ST is selected as a first chip area to be measured, the measurement is carried out clockwise from the alignment mark AM1 (see Fig. 9) of this chip area via AM2 and AM3 to AM4 in order (of course, the measurement can be carried out counterclockwise in the order of AM1, AM4, AM3, and AM2). After completion of the position measurement of the all alignment marks given to the chip area 64, the measurement is continued to measure the positions of the all alignment marks of the chip area 63. Subsequently, the positions of the all alignment marks of the chip area 62 are measured in the same manner and then the positions of the all alignment marks in the all chip areas are successively measured.

With the approach based on the rule of thumb used herein, the optimization of movement sequence for the position measurement of alignment marks was not effected taking account of such a route that before completion of the position measurement of the all alignment marks of one chip area, the measuring point visited an alignment mark of another chip area and thereafter again visited the remaining alignment marks of the first chip area. Therefore, the approach based on the rule of thumb takes a short time for computation, but it fails to effect the optimization taking full account of the various conditions of the positions of the respective alignment marks, except for restriction conditions such as the performance of the stage or the chip areas.

The solution obtained by the approach based on the rule of thumb was as shown in Fig. 1 where the measurement was conducted clockwise for the positions of the alignment marks in each chip area. The overall movement time of the resultant movement sequence (from the start point ST to the end point EN) was 53.149 sec. When the measurement was conducted counterclockwise for the positions of the alignment marks in each chip area, the overall movement time of the resultant movement sequence (from the start point ST to the end point EN) was 52.757 sec. In contrast, the overall movement time of the resultant movement sequence according to the optimum solution obtained by the GA of the MGG model described above was 49.052 sec. It is thus seen that the overall movement time can be shortened by about 3 sec from that of the movement sequence obtained by the approach based on the rule of thumb.

Linear Programming Method: Nearest Neighbor Method (NN method)

In general, even if a solution of local partial movement sequences is optimum, a movement sequence having such partial movement sequences will not be always an optimum solution. When this problem is solved by the linear programming method to obtain a solution, the resultant solution is not always the (globally) optimum solution. However, since the determining method of movement sequence according to the present invention is a method for generating a good solution, or a locally optimum solution very quickly, it is used as an effective near-optimum obtaining method where the point is to obtain a solution in a short time.

The nearest neighbor method (the NN method), which is one of most popular search methods, will be described herein as an embodiment by the linear programming method. The NN method is a method for repeating such an operation as to arbitrarily select one starting point and choose a nearest neighbor point thereto as a next point.

A point selected once will be excluded in order from a candidate group of next selection. In the search process of the best unit movement sequence, when there are plural candidates for the unit movement sequence selected next (or when there are plural candidates having an identical and shortest movement time of unit movement sequence for movement to the start point of the next position measurement of alignment mark) and if the all cases are searched, the search could be a search of all solutions in the worst case. For the purpose of decreasing the computation time by avoiding it, an idea to randomly select several points out of the next candidate points at each point (for example, in such a way as to preliminarily assume that p points are selected in the highest case and arbitrarily determine how many points should be selected between 1 and p, at each point) can be introduced.

In this embodiment the above number p is set to 1 and a solution is sought by the NN method while a search start position is selected from the end point EN and the all alignment marks. The reason is that when the above number p is 1 and if the search start position is fixed at the start point ST, we can find merely one solution. In this embodiment, however, the measurement start position is set to be the start point ST and the measurement end position to be the end point EN. In order to satisfy this constraint, the start point ST must follow the end point EN. Therefore, after the solution is obtained by the NN method, the units of the gene need to be shifted so as to start from the start point ST and end at the end point EN.

For quickly carrying out the algorithm of this type, it is preferable to make a movement time management table of movement patterns preliminarily contemplated and to write unit movement times of the respective patterns in the memory or the like. With a list of candidates for movement from a certain point to a next point, it is effective to sort the candidates in the order of unit movement times from the smallest. This operation makes it possible to select points not having passed yet one by one from the top of the candidate list. The same table of movement patterns is also utilized for increasing the efficiency of calculation of movement time similarly in the LK method and the evolutionary computation method.

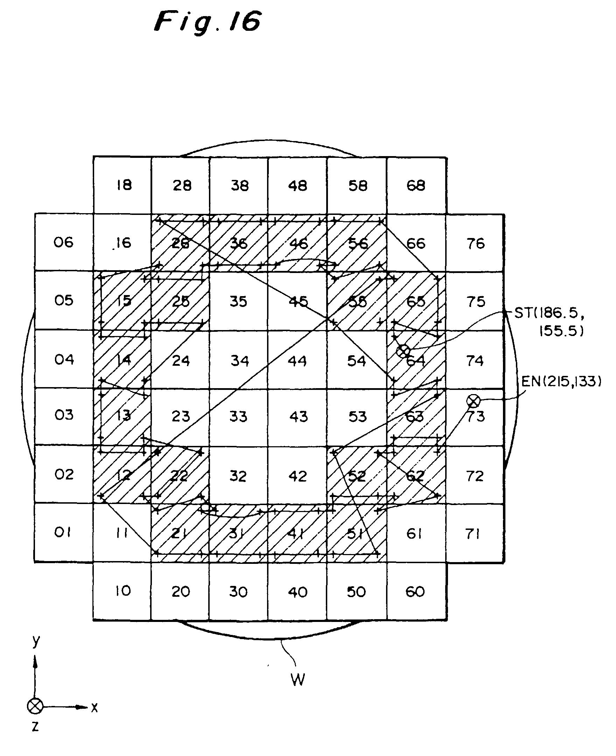

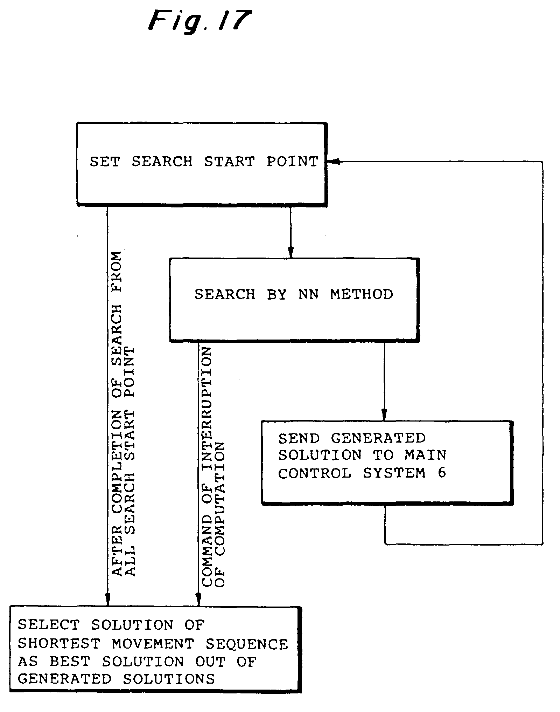

By employing such a method that every time a new solution is generated by the NN method, the best solution at that point is recorded in the memory 62 of the main control system 6, the best solution by the NN method at that time can be obtained even with interruption of computation on the way. For example, the operation in this embodiment is carried out according to the flowchart shown in Fig. 17. Eighty one solutions were generated by the NN method and the computation time for generation of the eighty one solutions was about 0.03 sec. As a result, the best solution by the NN method in this embodiment was as shown in Fig. 16, and the overall movement time of the movement sequence for the position measurement of the alignment marks (from the start point ST to the end point EN) was 49.614 sec.

Lin and Kernighan's approach (the LK method)

The LK method is famous as a quick near-optimum obtaining method for symmetric TSP (Traveling Salesman Problem),i.e., as a technique capable of obtaining a near-optimum solution in a very short turnaround time of computation and is a technique of development of the k-OPT method, which is the general name of the 2-OPT method and the 3-OPT method. Details of these techniques will be described hereinafter. The TSP is a problem: given an arbitrary city matrix for n (n > 1) cities, find a minimum-length tour that visits each city only once and the all cities. There are symmetric and asymmetric TSPs. The symmetric TSP is a TSP for an object in which the overall pathlength is invariant even with inversion of the tour order from the sequential city visit order given for the matrix of n cities. Conversely, the asymmetric TSP is a TSP for an object in which the overall pathlength will vary with inversion of the tour order from the above city visit order.

The TSP was originally the problem considered in order to minimize the length of the tour, for example, assuming that a matrix of cities are located randomly on a two-dimensional plane or the like. In such a city matrix space the shortest path between two arbitrary cities (i.e., an arbitrary unit path) is given uniquely by connecting the two cities by a straight line; therefore, once the visit order of the cities is determined, the minimum-length tour path according to the visit order can be obtained uniquely. Accordingly, finding a city visit order (city permutation) to minimize the length of the path to visit the all cities is equivalent to obtaining a solution to the TSP. Therefore, even if the objective problem is not directed to minimization of the path itself (i.e., a distance in a physical space) and if it is converted to one equivalent to the optimization of permutation, the approach of TSP can be applied as it is. For example, the technique of TSP can be applied as it is, to the problem to determine the movement sequence 60 as to minimize the overall movement time for the position measurement of the all alignment marks in the one-shot exposure type stepper. The movement times of unit movement sequences in this case are not distances between two arbitrary alignment marks, but they are the times as the memory contents in the movement time management table stored in the memory 62 (because the movement along the X-direction and the movement along the Y-direction of the wafer stage can be made independently and simultaneously). Let us consider below application of the "LK method" which can be regarded as an improvement of the k-OPT method.

The NN method is a "generating method" to generate a solution from nothing, while the k-OPT method and LK method are so-called "improving methods" for initially giving a certain initial solution (here, in the case of the "constraint satisfying problem" to require an output solution to satisfy a specific constraint, a necessary condition is that the initial solution is a feasible basic solution) and successively improving the solution. Particularly, the LK method is a method for repetitively performing such an operation as to extract a part of a tour sequence of the initial solution and to invert the partial order, thereby effecting repetitive improvements even in a solution after improved, as long as an improvement is possible.

In one improvement, if the sum of lengths of paths (two cut paths) at the both ends of the partial sequence extracted is smaller than that before the inversion, the length of the entire path will be shortened by the difference between them. Therefore, this method is efficient, because attention is focused only on the lengths of the two cut paths and computation is unnecessary for the total pathlength. This single improvement is called 2-OPT. After accomplishment of 2-OPT, when 2-OPT is again carried out in a combination of one end of the partial path extracted with another end this time, three ends are changed as a whole. This is called 3-OPT. These are generally called k-OPT. In the k-OPT the value of k is preliminarily given. Therefore, the k-OPT had a problem that it was not sufficiently adaptable to the case wherein the optimum k value varied depending upon the initial solution to be improved. However, the LK method updates k in k-OPT (from 2) one by one as long as an improvement is made. Thus the LK method overcame the problem in the k-OPT method.

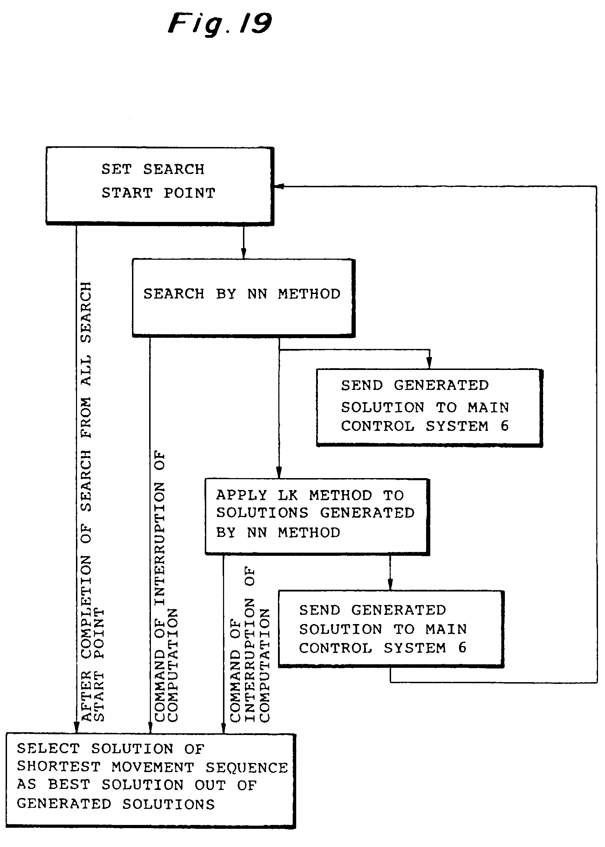

If the method is so arranged that every generation of a solution by the LK method the best solution at that point is stored in the memory 62 of the main control system 6, the best solution by the LK method at that time can be obtained even with interruption of computation on the way. For example, the operation of this embodiment is carried out according to the flowchart shown in Fig. 19.

In this embodiment the LK method is applied to near-optimum solutions obtained by the NN method. The LK method generates one improved solution per initial solution. Since one improved solution is generated per initial solution, the number of initial solutions should be determined preferably as high as possible. This embodiment employs an approach method for using eighty one solutions obtained by the NN method as initial solutions and improving them.

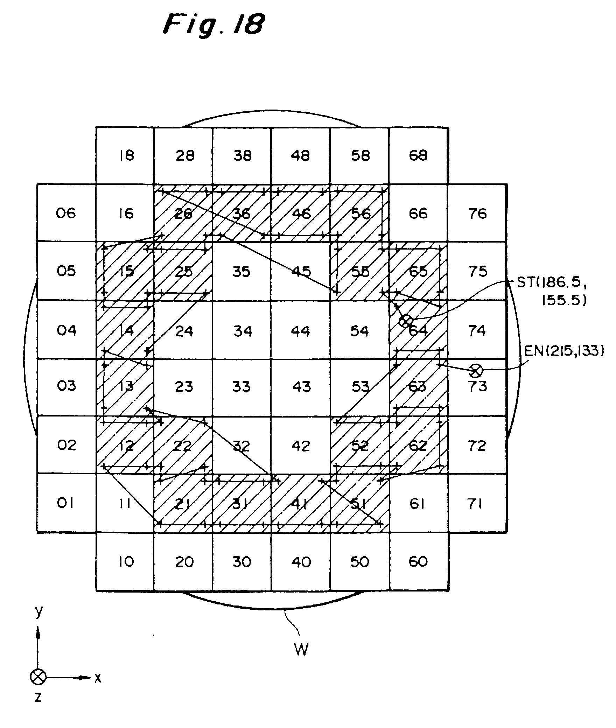

The computation time was about 0.14 sec for obtaining eighty one solutions by applying the LK method to the all eighty one solutions resulting from the forward search of the NN method. Since the computation time becomes longer with more improved portions by the LK method, it is not simply proportional to the number of initial solutions to be improved. The result of this experiment showed that when the solutions by the NN method were used as initial solutions of the LK method, the best solution was the solution of the movement sequence shown in Fig. 18 and the overall movement time of the movement sequence was 49.117 sec.

Approach based on the evolutionary computation method

Next described is the approach based on the evolutionary computation method according to the present invention. An initial group is first generated. Since the shortest movement times of the above unit movement sequences are already recorded in the two-dimensional table (see Fig. 7), for example, if a movement sequence is arbitrarily produced so as to pass each alignment mark only once without duplication with reference to this table, a gene indicating an arbitrary feasible basic solution can be generated. Using plural genes (each of which is a feasible basic solution) arbitrarily generated as described, as an initial group, preliminary experiments were repetitively conducted with different group sizes, crossover rates, and mutation rates. The preliminary experiments verified that the same solution as the optimum solution, which was obtained by 20-hour computation by the GA of the MGG model described above, was generated within about 20 seconds under such setting conditions that the group size N = the number of alignment marks, the crossover rate Pc = 0.4, and the shift mutation rate Pm = 0.4 and that the LK operator was applied to the all genes.

Further, experiments were conducted using the solutions obtained by the above LK method as initial solutions. It is highly possible that a solution obtained by the NN method + the LK method (i.e., by the LK method using the solutions obtained by the NN method, as initial solutions) is a local solution in the optimization problem of measurement process sequence of coordinates of the alignment marks (which is a locally optimum solution, but is not a true optimum solution or a globally optimum solution). This thus raises a risk of biasing the solution search space in the global search by the GA (i.e., a risk of search biased to near the local solution). In order to avoid it, the initial group should desirably include a solution of good quality representing a completely different movement sequence, as well as the best solution by the NN method + the LK method. If the added solution, though representing the completely different movement sequence, is not of good quality, it will be dismissed to be extinct soon in the GA. Therefore, this example employed a method for sampling solutions without replacement by the number equivalent to the group size (N) at predetermined probabilities, each at a probability consistent with an evaluation value of each solution, out of the solutions obtained by the NN method and the solutions obtained by applying the LK method to the all solutions obtained by the NN method, in addition to the best solution obtained by the NN method + the LK method (the roulette wheel selection). This group of solutions was used as an initial gene group in the GA.

With the above group being used as an initial gene group and under such setting conditions that the group size N = the number of alignment marks, the crossover rate Pc = 0.4, and the shift mutation rate Pm = 0.4 and that the LK operator was applied to the all genes, the GA stably generated a solution superior to that by the LK method within 2 sec and also generated the same solution as the optimum solution obtained after 20-hour computation by the GA of the MGG model, within 10 sec.

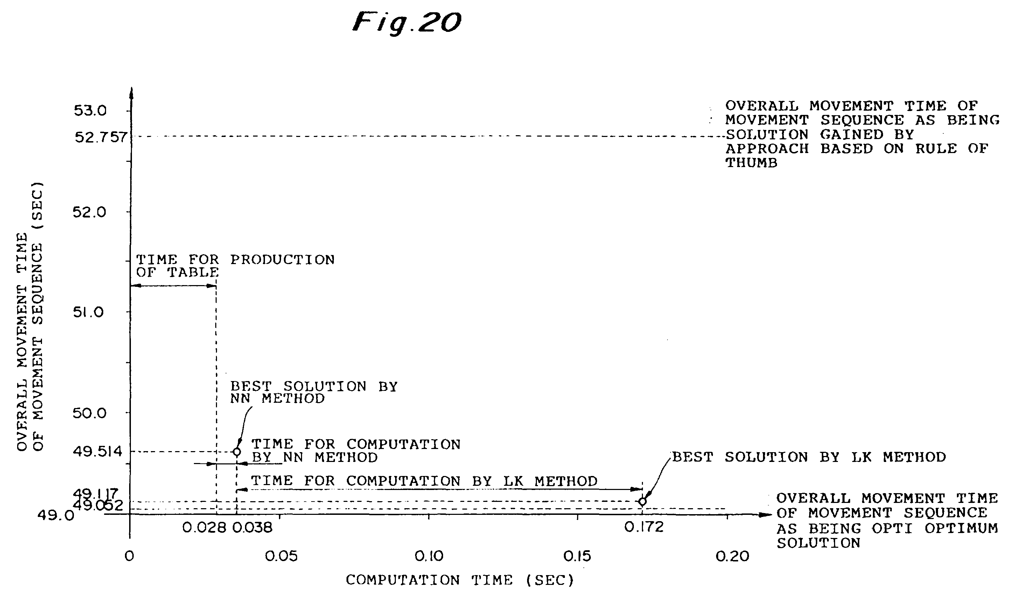

Fig. 20 to Fig. 22 are drawings to show relations among the various approaches described above, computation times necessary for such approaches, and overall movement times of movement sequences obtained by the approaches. The ordinate indicates the overall movement time of movement sequence obtained and the abscissa the computation time. The units are sec.

Fig. 20 is a drawing to illustrate the overall movement time of the movement sequence of the solution obtained by the approach based on the rule of thumb, the time necessary for obtaining the best solution by the NN method and the overall movement time of the movement sequence being the solution that time, and the computation time necessary for obtaining the best solution by the LK method using the solution set by the NN method as initial solutions and the overall movement time of the movement sequence being the solution that time.

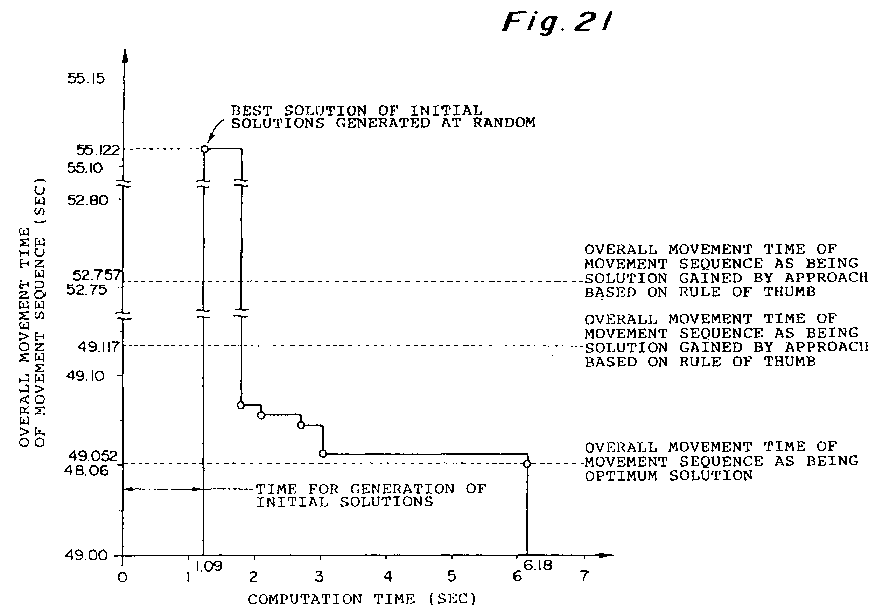

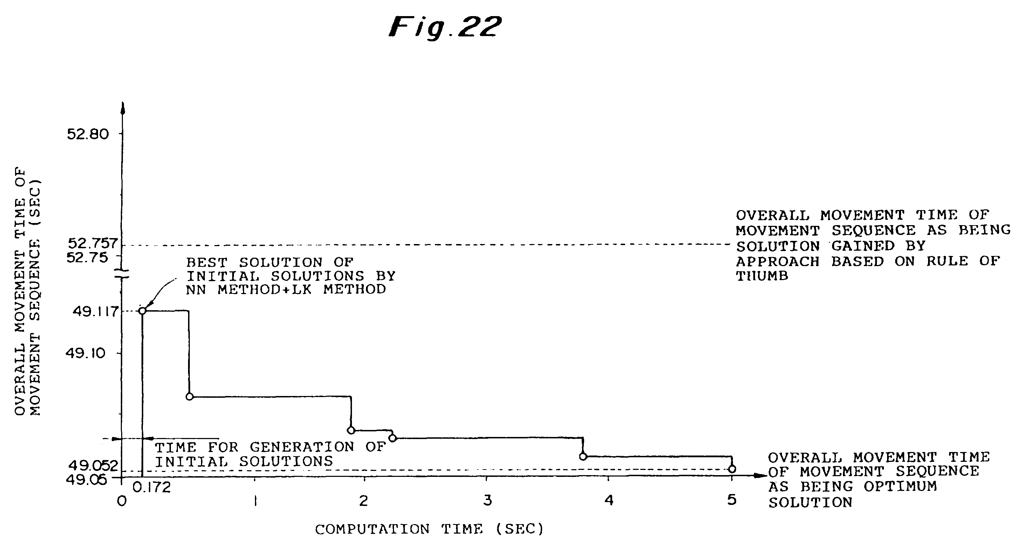

Fig. 21 is a drawing to show the result achieved when the GA was applied to an initial group as being a set of solutions consisting of the feasible basic solutions randomly generated as described above. Further, Fig. 22 is a drawing to show the result achieved when the GA was applied to an initial group as being a set of solutions consisting of the solutions obtained by the NN method + the LK method. It is apparent from either figure that the best solution is updated with progress in alteration of generation. For comparison's sake, Fig. 21 and Fig. 22 also show the overall movement time of the movement sequence of the solution obtained by the approach based on the rule of thumb and the overall movement time of the movement sequence of the best solution obtained by the LK method using the solution set by the NN method as an initial solution group. The best solution obtained by the GA shown in Fig. 21 was obtained in the computation time of 6.18 sec and the overall movement time of the movement sequence being the best solution obtained was 49.052 sec. Similarly, the best solution obtained by the GA shown in Fig. 22 was obtained in the computation time of 5.00 sec and the overall movement time of the movement sequence obtained was 49.052 sec.

The above experiments were conducted on a workstation provided with the CPU of 200 MHz. It should be noted that the above computation times naturally differ depending upon the performance of the CPU or the like.

In Figs. 1 and 2 each showing a sequence obtained by the conventional approach based on the rule of thumb, after measuring all alignment marks provided in the selected chip area, marks in a next chip area, which is successively selected clockwise or counterclockwise, are measured. On the other hand, in Figs. 15, 16 and 18 each showing a sequence obtained by the approach according to the present invention, it can be understood that a measurement for a next chip area after measuring for a part of marks in the selected chip area is performed, and thereafter the remaining marks are measured in the selected chip again after measuring the marks in the next chip area. For example, in Fig. 15, after measuring two alignment marks in the chip area 31, the measurements for the chip areas 21, 12 and 22 are successively performed, and thereafter the remaining marks are measured in the chip area 31 again. In Fig. 16, after measuring two alignment marks in the chip area 31, the measurements for the chip areas 21, 12, 55, ... and 22 are successively performed, and thereafter the remaining marks are measured in the chip area 31 again. Further, in Fig. 18, after measuring two alignment marks in the chip area 31, the measurements for the chip areas 21 and 22 are successively performed, and thereafter the remaining marks are measured in the chip area 31 again.

From the invention thus described, it will be obvious that the invention may be varied in many ways. Such variations are not to be regarded as a departure from the spirit and scope of the invention, and all such modifications as would be obvious to one skilled in the art are intended for inclusion within the scope of the following claims.

**Claims**

1. A determining method of movement sequence for determining an order of measurement of a plurality of measurement target areas, comprising:

   an arithmetic step of obtaining a solution of a most preferable movement sequence with respect to an overall movement time between said plurality of measurement target areas.

2. A method according to claim 1, wherein said arithmetic step includes:

   a first step of generating a group including a plurality of executable movement sequences out of a group of movement sequences, each indicating a measurement order of said plurality of measurement target areas; and
   a second step of selecting a movement sequence that can accomplish a movement operation between said plurality of target areas in the shortest time, out of said group generated.

3. A method according to claim 2, further comprising a pre-step carried out prior to said arithmetic step, said pre-step being a step of producing a movement time management table in which for each of said plurality of measurement target areas, a movement time is recorded as a time necessary for movement of the target area of interest from a position thereof at the time of completion of position measurement of either one of said plurality of measurement target areas into said measuring area of the measuring system.

4. A method according to claim 3, wherein said movement time management table includes such information that for a pair of measurement target areas selected out of said plurality of measurement target areas, after completion of the position measurement of one measurement target area selected, the other measurement target area selected is prohibited from moving from a position thereof at the time of completion of the position measurement of the one measurement target area selected into said measuring area of the measuring system.

5. A method according to claim 2, wherein said search technique includes at least one of a method based on operations-research technique, an evolutionary computation method, and a combination thereof.

6. A method according to claim 5, wherein said method based on operations-research technique includes at least one of a linear programming method, a Lin and Kernighan's approach, and a k-OPT method.

7. A method according to claim 6, wherein said linear programming method is a method arranged in such a manner that when there exist plural near solutions to the best solution of a movement sequence to be obtained, a plurality of good solutions are generated by recomputation with change in a method for selecting one specific solution or with change in a search start point and a moot preferable, good solution with respect to the overall movement time between said plurality of measurement target areas is selected out of the plurality of good solutions thus generated.

8. A method according to claim 6, wherein said combination method including said linear programming method is a method arranged in ouch a manner that, using a plurality of first good solutions obtained by said linear programming method for a movement sequence to be obtained, as initial solutions, a plurality of second good solutions are generated by the Lin and Kernighan's approach or the k-OPT method and a most preferable, second good solution with respect to the overall movement time between said plurality of target areas is selected out of said plurality of second good solutions thus generated.

9. A method according to claim 2, wherein said search technique obtains a solution of a most preferable movement sequence with respect to the overall movement time between said plurality of target areas by use of a genetic algorithm, using constraint satisfying solutions generated at random, as initial solutions.

10. A method according to claim 2, wherein said search technique obtains a solution of a most preferable movement sequence with respect to the overall movement time between said plurality of target areas by use of a genetic algorithm, using solutions obtained by at least one of a linear programming method, a Lin and Kernighan's approach, a k-OPT method, and a combination thereof, as initial solutions.

11. A method according to claim 10, wherein an execution time of said arithmetic step using said genetic algorithm is shortened by improvement in solutions of movement sequences updated on occasion during execution of said genetic algorithm by one of the Lin and Kernighan's approach and the k-OPT method.

12. A method according to claim 10, wherein said genetic algorithm has a mutation operator, said mutation operator having an operator for changing an order of measurement of measurement target areas selected from said plurality of measurement target areas.

13. A method according to any one of preceding claims, wherein said measurement is performed for achieving alignment between a pattern of an original plate and each chip area on the substrate.

14. An alignment apparatus for successively measuring positions of a plurality of alignment marks as becoming measurement targets provided on a substrate and performing alignment between a transfer position of a pattern of an original plate and each chip area on the substrate by use of a statistical arithmetic method based on information of the positions of the respective alignment marks obtained, said alignment apparatus comprising:

   a measuring device for measuring each of the positions of said plurality of alignment marks;
   a moving device for effecting relative movement between said plurality of alignment marks and a measuring area of said measuring device;
   an arithmetic section for obtaining a solution of a most preferable movement sequence with respect to an overall movement time between said plurality of alignment marks; and
   a control section for controlling said moving device so as to successively move said plurality of alignment marks into the measuring area of said measuring device, according to a solution of the movement sequence obtained by said arithmetic section.

15. An apparatus according to claim 14, wherein said arithmetic section generates a group of a plurality of executable movement sequences out of a group of movement sequence, each indicating a measurement order of said plurality of alignment marks, and selects a movement sequence that accomplishes a movement operation between said plurality of alignment marks within the shortest time, out of said group generated.

16. An apparatus according to claim 15, further comprising a memory for storing a movement time management table in which for each of said plurality of alignment marks, a movement time is recorded as a time necessary for movement of the alignment mark of interest from a position thereof at the time of completion of position measurement of either one of said plurality of alignment marks into said measuring area of the measuring device.

17. An apparatus according to claim 16, wherein said movement time management table stored in said memory includes such information that for a pair of alignment marks selected out of said plurality of alignment marks, after completion of the position measurement of one alignment mark selected, the other alignment mark selected is prohibited from moving from a position thereof at the time of completion of the position measurement of the one alignment mark selected into said measuring area of the measuring device.

18. An apparatus according to claim 15, wherein said arithmetic section executes a search technique of at least one of a method based on operations-research technique, an evolutionary computation method, and a combination thereof.

19. A determining method of movement sequence for determining an order of measurement of a plurality of measurement target areas, comprising:

a first measurement step of measuring a measurement target area in a first chip area; and

a second measuring step of measuring a measurement target area of a second chip area which is not a nearest one from said first chip area in regard to distance.

20. A method according to claim 19, wherein said measurement is performed for achieving alignment between a pattern of an original plate and each chip area on the substrate.

21. A determining method of measurement target areas in each chip area, comprising:

a first measuring step of measuring a measurement target area in a first chip area;
a second measurement step of measuring a measurement target area in a second chip area after said first measuring step; and
a third measuring step of measuring a remaining measurement target area in said first chip area after said second measuring step.

22. A method according to claim 21, wherein said first area has three and more measurement target areas.

23. A method according to claim 21 or 22, further comprising a fourth measuring step of measuring measurement target area in at least one of other chip areas between said second measuring step and third measuring step.

24. A method according to any one of preceding claims 21-23, wherein said measurement is performed for achieving alignment between a pattern of an original plate and each ship area on the substrate.

## Fig. I

# Fig.2

# Fig. 3

## Fig. 4

START

OPERATOR SELECTS CHIP AREAS FOR EGA MEASUREMENT — ST101

DETERMINES IS NUMBER OF MARKS THAT SHOULD BE MEASURED OUT OF ALIGNMENT MARKS IN THE CHIP AREAS SELECTED BY OPERATOR — ST103

ST105

WAFER IS LOADED

ST109

MEASUREMENT ORDER OF COORDINATES OF ALIGNMENT MARKS IS DETERMINED BY SEARCH TECHNIQUE (GENETIC ALGORITHM ETC)

XY STAGE IS MOVED TO START POINT ST OF MEASUREMENT WITH ALIGNMENT OPTIC SYSTEM

ST107

XY STAGE IS MOVED ACCORDING TO MARK MEASUREMENT ORDER OBTAINED BY GENETIC ALGORITHM, AND COORDINATES OF ALIGNMENT MARKS ARE MEASURED BY ALIGNMENT SYSTEM EVERY AFTER MOVEMENT — ST111

XY STAGE IS MOVED TO END POINT EN OF MEASUREMENT OF ALIGNMENT OPTIC SYSTEM — ST113

EGA ARITHMETIC IS EXECUTED — ST115

RETICLE IS ALIGNED WITH WAFER ACCORDING TO RESULT OF EGA AND EXPOSURE IS DONE — ST117

*Fig.5*

| ATTRIBUTE | | VALUE OF PARAMETER SET IN EMBODIMENT |
|---|---|---|
| START POINT ST | X | 186.5 (mm) |
| | Y | 155.5 (mm) |
| END POINT EN | X | 215 (mm) |
| | Y | 133 (mm) |
| ACCELERATION OF WAFER STAGE 10 | X | 0.34g |
| | Y | 0.2g |
| MAX SPEED OF WAFER STAGE 10 | X | 270 (mm/sec) |
| | Y | 200 (mm/sec) |
| SETTLING TIME OF WAFER STAGE | | 0.032 (sec) |
| TIME NECESSARY FOR MEASURING COORDINATES OF ONE ALIGNMENT MARK | | 0.5 (sec) |

g:ACCELERATION OF GRAVITY (=9.80m/sec)

*Fig.6*

| CHIP AREA | COORDINATES OF CENTER | CHIP AREA | COORDINATES OF CENTER |
|---|---|---|---|
| 12 | (83, 105) | 41 | (149, 83) |
| 13 | (83, 127) | 46 | (149, 193) |
| 14 | (83, 149) | 51 | (171, 83) |
| 15 | (83, 171) | 52 | (171, 105) |
| 21 | (105, 83) | 55 | (171, 171) |
| 22 | (105, 105) | 56 | (171, 193) |
| 25 | (105, 171) | 62 | (193, 105) |
| 26 | (105, 193) | 63 | (193, 127) |
| 31 | (127, 83) | 64 | (193, 149) |
| 36 | (127, 193) | 65 | (193, 171) |

EP 0 864 929 A2

**Fig.7**

| | START | 12(1) | 12(2) | 12(3) | 12(4) | 13(1) | 13(2) | |
|---|---|---|---|---|---|---|---|---|
| 12(1) | 0.378296 | × | 0.109449 | 0.132981 | 0.132981 | 0.142 | 0.142 | ... |
| 12(2) | 0.45237 | 0.109449 | × | 0.132981 | 0.132981 | 0.142 | 0.142 | ... |
| 12(3) | 0.45237 | 0.132981 | 0.132981 | × | 0.109449 | 0.242 | 0.242 | ... |
| 12(4) | 0.378296 | 0.132981 | 0.132981 | 0.109449 | × | 0.242 | 0.242 | ... |
| 13(1) | 0.378296 | 0.142 | 0.142 | 0.242 | 0.242 | × | 0.109449 | ... |
| 13(2) | 0.45237 | 0.142 | 0.142 | 0.242 | 0.242 | 0.109449 | × | ... |
| ⋮ | | | | ⋮ | | | | |
| 64(3) | 0.123721 | 0.36533 | 0.439407 | 0.439407 | 0.365333 | 0.365333 | 0.439407 | ... |
| 64(4) | 0.123721 | 0.439407 | 0.513481 | 0.513481 | 0.439407 | 0.439407 | 0.513481 | ... |
| 65(1) | 0.1595 | 0.439407 | 0.513481 | 0.513481 | 0.462 | 0.439407 | 0.513481 | ... |
| 65(2) | 0.1595 | 0.36533 | 0.439407 | 0.462 | 0.462 | 0.365333 | 0.439407 | ... |
| 65(3) | 0.084955 | 0.36533 | 0.439407 | 0.439407 | 0.365333 | 0.365333 | 0.439407 | ... |
| 65(4) | 0.102346 | 0.439407 | 0.513481 | 0.513481 | 0.439407 | 0.439407 | 0.513481 | ... |
| END | × | 0.483852 | 0.557926 | 0.557926 | 0.483852 | 0.483852 | 0.557926 | ... |

F

(UNIT:SEC)

| | 64(3) | 64(4) | 65(1) | 65(2) | 65(3) | 65(4) |
|---|---|---|---|---|---|---|
| ... | 0.365333 | 0.439407 | 0.439307 | 0.365333 | 0.365333 | 0.439407 |
| ... | 0.439407 | 0.513481 | 0.513481 | 0.439407 | 0.439407 | 0.513481 |
| ... | 0.439407 | 0.513481 | 0.513481 | 0.462 | 0.439407 | 0.513481 |
| ... | 0.365333 | 0.439407 | 0.462 | 0.462 | 0.365333 | 0.439407 |
| ... | 0.365333 | 0.439407 | 0.439407 | 0.365333 | 0.365333 | 0.439407 |
| ... | 0.439407 | 0.513481 | 0.513481 | 0.439407 | 0.439407 | 0.513481 |
| ⋮ | | | | | | |
| ... | × | 0.109449 | 0.242 | 0.242 | 0.142 | 0.142 |
| ... | 0.109449 | × | 0.242 | 0.242 | 0.142 | 0.142 |
| ... | 0.242 | 0.242 | × | 0.109449 | 0.132981 | 0.132981 |
| ... | 0.242 | 0.242 | 0.109449 | × | 0.132981 | 0.132981 |
| ... | 0.142 | 0.142 | 0.132981 | 0.132981 | × | 0.109449 |
| ... | 0.142 | 0.142 | 0.132981 | 0.132981 | 0.109449 | × |
| ... | 0.150519 | 0.091992 | 0.272 | 0.272 | 0.172 | 0.172 |

# Fig. 8

## Fig. 9

AM4(-10, 10)　　AM1(10, 10)

AO(0,0)

AM3(-10, -10)　AM2(10, -10)

## Fig. 10

AM1' (0, 10)

AM4' (-10, 0)　　AM2' (10,0)

BO(0,0)

AM3' (0, -10)

# Fig. 11

```
┌─────────────────────────────────┐
│ PRODUCTION OF GROUP Gt OF       │──── ST12
│ STARTING GENES (t=1)            │
└─────────────────────────────────┘
         │
         ↓
   ┌─────────────────────────┐
   │ SELECTION 1:            │──── ST14
   │   CROSSOVER RATE Pc     │
   └─────────────────────────┘
         │
         ↓
   ┌─────────────────────────┐
   │ EXECUTION OF SUBTOUR    │──── ST16
   │ EXCHANGE CROSSOVER      │
   └─────────────────────────┘
         │
         ↓
   ┌─────────────────────────┐
   │ GROUP OF NEW-BORN       │──── ST18
   │ GENES:A                 │
   └─────────────────────────┘
         │
         ↓
       ┌─────────────────────────┐
       │ SELECTION 2:            │──── ST20
       │ MUTATION RATE Pm        │
       └─────────────────────────┘
         │
         ↓
       ┌─────────────────────────┐
       │ MUTATION                │──── ST22
       └─────────────────────────┘
         │
         ↓
       ┌─────────────────────────┐
       │ GROUP OF NEW-BORN       │──── ST24
       │ GENES:B                 │
       └─────────────────────────┘
         │
         ↓
┌─────────────────────────────────────────┐
│ GROUP OF NEW-BORN GENES : Gt+A+B         │
└─────────────────────────────────────────┘
                              ST26
         │
         ↓
   ┌─────────────────────────┐
   │ SURVIVAL SELECTION      │──── ST36
   └─────────────────────────┘
         │
         ↓
┌─────────────────────────────────┐
│ PRODUCTION OF GROUP Gt OF       │──── ST38
│ STARTING GENES (t=t+1)          │
└─────────────────────────────────┘
```

## Fig. 12

```
PRODUCTION OF GROUP Gt OF          ST12
STARTING GENES (t=1)

                SELECTION 1 :              ST14
                CROSSOVER RATE Pc

                EXECUTION OF SUBTOUR       ST16
                EXCHANGE CROSSOVER

                GROUP OF NEW-BORN          ST18
                GENES : A

                              SELECTION 2:          ST20
                              MUTATION RATE Pm

                              MUTATION              ST22

                              GROUP OF NEW-BORN     ST24
                              GENES : B

                GROUP OF NEW-BORN          ST28
                GENES : A+B

                                     ST30

                              LK OPERATOR

                              GROUP OF NEW-BORN
                              GENES : C
            ST34                              ST32

        GROUP OF NEW-BORN GENES : Gt+A+B+C

                SURVIVAL SELECTION         ST36

                PRODUCTION OF GROUP Gt OF  ST38
                STARTING GENES (t=t+1)
```

27

## Fig. 13

P1: | A | B | C | D | E | F | G | H |

IDENTICAL PARTIAL SETS
OF ALIGNMENT MARKS

P2: | B | A | H | D | F | E | C | G |

CROSSOVER

C1: | A | B | D | F | E | C | G | H |

EXCHANGE

C2: | B | A | H | C | D | E | F | G |

C3: | A | B | C | E | F | D | G | H |

INVERSION OF ORDER

C4: | B | A | H | F | E | D | C | G |

# Fig. 14

P3 | A | B | C | D | E | F | G | H |

2 UNITS

IDENTICAL PARTIAL
SETS OF ALIGNMENT
MARKS

P4 | F | A | H | D | B | E | C | G |

MUTATION

C5 | A | D | E | B | C | F | G | H |

SHIFTED BY 2 UNITS

C6 | F | A | H | E | C | D | B | G |

29

## Fig. 15

# Fig. 16

## Fig. 17

```
┌─────────────────────────────────┐
│                                 │◄──────────────┐
│   SET  SEARCH  START  POINT     │               │
│                                 │               │
└─────────────────────────────────┘               │
     │                    │                        │
     │                    ▼                        │
     │         ┌──────────────────────────┐        │
     │         │                          │        │
     │         │   SEARCH  BY  NN METHOD  │        │
     │         │                          │        │
     │         └──────────────────────────┘        │
     │              │          │                    │
     │              │          ▼                    │
     │              │   ┌──────────────────────┐    │
     │              │   │  SEND GENERATED      │    │
     │              │   │  SOLUTION TO MAIN    │    │
     │              │   │  CONTROL SYSTEM 6    │    │
     │              │   └──────────────────────┘    │
     │              │              │                │
     │              │              └────────────────┘
     │              │
```

AFTER COMPLETION OF SEARCH FROM ALL SEARCH START POINT

COMMAND OF INTERRUPTION OF COMPUTATION

```
     ▼              ▼
┌────────────────────────────────┐
│  SELECT SOLUTION OF            │
│  SHORTEST MOVEMENT SEQUENCE    │
│  AS BEST SOLUTION OUT OF       │
│  GENERATED SOLUTIONS           │
└────────────────────────────────┘
```

# Fig. 18

# Fig. 19

```
                    ┌─────────────────┐
                    │   SET SEARCH    │◄──────────────────────┐
                    │  START POINT    │                       │
                    └────────┬────────┘                       │
                             │                                │
                             ▼                                │
                    ┌─────────────────┐                       │
                    │ SEARCH BY NN METHOD │                   │
                    └─────────────────┘                       │
                             │                                │
                             │      ┌──────────────────┐      │
                             │      │ SEND GENERATED   │      │
                             │      │ SOLUTION TO MAIN │      │
                             │      │ CONTROL SYSTEM 6 │      │
                             │      └──────────────────┘      │
                             ▼                                │
                    ┌─────────────────────┐                  │
                    │ APPLY LK METHOD TO   │                 │
                    │ SOLUTIONS GENERATED  │                 │
                    │ BY NN METHOD         │                 │
                    └─────────────────────┘                  │
                             │                                │
                             ▼                                │
                    ┌──────────────────┐                     │
                    │ SEND GENERATED   │                     │
                    │ SOLUTION TO MAIN │                     │
                    │ CONTROL SYSTEM 6 │─────────────────────┘
                    └──────────────────┘
```

AFTER COMPLETION OF SEARCH FROM ALL SEARCH START POINT

COMMAND OF INTERRUPTION OF COMPUTATION

COMMAND OF INTERRUPTION OF COMPUTATION

SELECT SOLUTION OF
SHORTEST MOVEMENT SEQUENCE
AS BEST SOLUTION OUT OF
GENERATED SOLUTIONS

# Fig.20

OVERALL MOVEMENT TIME OF MOVEMENT SEQUENCE AS BEING SOLUTION GAINED BY APPROACH BASED ON RULE OF THUMB

TIME FOR PRODUCTION OF TABLE

BEST SOLUTION BY NN METHOD

TIME FOR COMPUTATION BY NN METHOD

TIME FOR COMPUTATION BY LK METHOD

BEST SOLUTION BY LK METHOD

OVERALL MOVEMENT TIME OF MOVEMENT SEQUENCE AS BEING OPTI OPTIMUM SOLUTION

OVERALL MOVEMENT TIME OF MOVEMENT SEQUENCE (SEC)

COMPUTATION TIME (SEC)

EP 0 864 929 A2

Fig. 21

BEST SOLUTION OF INITIAL SOLUTIONS GENERATED AT RANDOM

OVERALL MOVEMENT TIME OF MOVEMENT SEQUENCE AS BEING SOLUTION GAINED BY APPROACH BASED ON RULE OF THUMB

OVERALL MOVEMENT TIME OF MOVEMENT SEQUENCE AS BEING SOLUTION GAINED BY APPROACH BASED ON RULE OF THUMB

OVERALL MOVEMENT TIME OF MOVEMENT SEQUENCE AS BEING OPTIMUM SOLUTION

TIME FOR GENERATION OF INITIAL SOLUTIONS

COMPUTATION TIME (SEC)

OVERALL MOVEMENT TIME OF MOVEMENT SEQUENCE (SEC)

55.15
55.122
55.10
52.80
52.757
52.75
49.117
49.10
49.052
48.06
49.00

0   1.09   2   3   4   5   6   6.18   7

Fig.22

OVERALL MOVEMENT TIME OF MOVEMENT SEQUENCE (SEC)

52.80

52.757

52.75

OVERALL MOVEMENT TIME OF MOVEMENT SEQUENCE AS BEING SOLUTION GAINED BY APPROACH BASED ON RULE OF THUMB

BEST SOLUTION OF INITIAL SOLUTIONS BY NN METHOD+LK METHOD

49.117

49.10

TIME FOR GENERATION OF INITIAL SOLUTIONS

49.052

49.05

0.172

0    1    2    3    4    5

COMPUTATION TIME (SEC)

OVERALL MOVEMENT TIME OF MOVEMENT SEQUENCE AS BEING OPTIMUM SOLUTION

EP 0 864 929 A2